# EUROPEAN PATENT APPLICATION

(11) **EP 4 592 751 A2**
(43) Date of publication of application: **30.07.2025**
(21) Application number: 25152752.9
(22) Date of filing: 20.01.2025
(51) Int. Cl.: G03F 7/075, G03F 7/11

(54) **COMPOSITION FOR FORMING ADHESIVE FILM AND PATTERNING PROCESS**

(30) Priority: 23.01.2024 JP 2024008333
(71) Applicant: SHIN-ETSU CHEMICAL CO., LTD., Tokyo 1000005 (JP)
(72) Inventor: Kobayashi, Naoki, Niigata (JP); Ishiwata, Kenta, Niigata (JP); Takizawa, Kanata, Niigata (JP)
(74) Representative: Sonnenhauser, Thomas Martin

(57) **Abstract**

The present invention provides a composition for forming an adhesive film, that is a material for forming an adhesive film between a silicon-containing middle layer film and a resist upper layer film, and is used for forming an adhesive film capable of contributing to sensitivity enhancement while effectively controlling pattern collapse. Provided is a composition for forming an adhesive film containing: (A) an organic polymer, (B) a metal source, and (C) an organic solvent, wherein the organic polymer (A) is a polymer compound containing one or both of repeating units represented by the formulae (1) and (2), and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 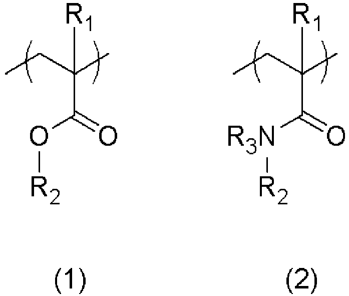 wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.

## Description

### TECHNICAL FIELD

The present invention relates to: a composition for forming an adhesive film usable for fine patterning by a multilayer resist method during semiconductor apparatus manufacturing processes; and a patterning process using the composition.

### BACKGROUND ART

As higher integration and speed are achieved in LSI, miniaturization of a pattern rule progresses rapidly. In particular, logic devices used in smartphones, etc. lead the miniaturization, and 10-nm node logic devices are produced in large quantities using a multiple exposure (multi-patterning lithography) process by ArF lithography.

Regarding lithography of next 7-nm node and 5-nm node, increased cost due to multiple exposure and a problem of overlay accuracy of multiple exposure become apparent, and the advent of EUV lithography enabling to reduce the number of exposure is desired.

Since extreme ultraviolet (EUV) has a short wavelength of 13.5 nm, that is equal to or shorter than 1/10 of that of an ArF excimer laser having a wavelength of 193 nm, EUV lithography achieves a high light contrast and is expected to have high resolution. Because of the short wavelength and high energy density of EUV, an acid generator is sensitive to a small amount of photons. It is believed that the number of photons in EUV exposure is 1/14 of that of ArF exposure. In the EUV exposure, a phenomenon in which variation in photons causes degraded line width roughness (LWR) and critical dimension uniformity (CDU) of a hole is considered as a problem (Non Patent Document 1). Furthermore, possible influences of localization or agglomeration of a base polymer or an acid generator as well as acid diffusion caused by an acid generator are also pointed out.

To address these, for example, it is possible to reduce LWR by decreasing temperature during post exposure bake (PEB), but sensitivity of an EUV resist is reduced. Furthermore, LWR is also reduced by increasing an amount of a quencher to be added, but this method also leads to the reduced sensitivity. For the practical application of an EUV resist, it is necessary to overcome the trade-off relationship between sensitivity and LWR.

In order to put EUV lithography into practical application as a mass-production process of semiconductor apparatuses, there are many problems to be solved. Among the problems, the property particularly required to be improved is to enhance sensitivity while keeping LWR. Patent Document 1 has disclosed a method for forming a lower layer film including a sensitizer, the sensitizer absorbing EUV light and generating a secondary electron. Patent Document 2 has disclosed that a thermosetting silicon-containing material that contains iodine is capable of contributing to sensitivity enhancement of an upper layer resist while keeping LWR thereof. However, for the above material design, an incorporation rate of an element with high optical absorption is limited, and it is considered that material design contributing more to the sensitivity enhancement of a resist is necessary.

To address the above problem, a possible method is by means of introduction of a resist underlayer film containing a metal element with a high absorption coefficient at EUV light. Patent Document 3 has disclosed a composition of spin-on materials containing metal oxide nanoparticles and an organic polymer. Although the evaluation of pattern formation in an EUV resist has not been mentioned, it is assumed that a resist underlayer film containing many metal elements with high optical absorption can be formed. However, since a film formed using metal nanoparticles has crystallinity, there is a risk of degraded line width roughness (LWR) of a pattern during etching of a substrate to be processed if nanoparticles are used in the resist underlayer film material.

Patent Document 4 has proposed a resist composition including a polymer containing repeating units having an acid labile group-substituted carboxyl group or a phenolic hydroxy group, an acid generator, and various metal salts of carboxylic acid or various metal complexes of β-diketone. In this case, acid generated by the acid generator undergoes ion exchange with the various metal salts of carboxylic acid or various metal complexes of β-diketone, and as a result, the acid is trapped. The metal salt of carboxylic acid or the metal complex of β-diketone functions as a quencher for the acid catalyst, and is effective for controlling acid diffusion but not actively enhancing sensitivity. A breakthrough is desired to increase sensitivity while controlling acid diffusion.

### CITATION LIST

### PATENT LITERATURE

Patent Document 1: JP 5705103 B
Patent Document 2: JP 2020-084175 A
Patent Document 3: JP 7008075 B
Patent Document 4: JP 5601286 B

### NON PATENT LITERATURE

Non Patent Document 1: SPIE, Vol. 3331, p. 531 (1998)

### SUMMARY OF INVENTION

### TECHNICAL PROBLEM

In view of the circumstances, the present invention aims to provide: a composition for forming an adhesive film, that is a material for forming an adhesive film between a silicon-containing middle layer film and a resist upper layer film, and is used for forming an adhesive film capable of contributing to sensitivity enhancement while effectively controlling pattern collapse; and a patterning process using this composition.

### SOLUTION TO PROBLEM

To achieve the above object, the present invention provides a composition for forming an adhesive film that is formed between a silicon-containing middle layer film and a resist upper layer film, the composition containing:
(A) an organic polymer, (B) a metal source, and (C) an organic solvent,
   wherein the organic polymer (A) is a polymer compound containing one or both of repeating units represented by the following formulae (1) and (2), and
   the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 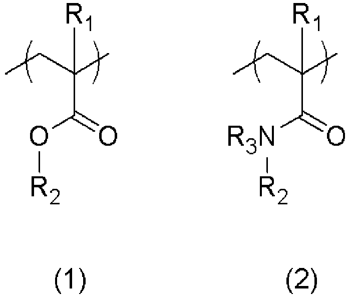
   wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.

Such composition for forming an adhesive film enables to form an adhesive film excellent in adhesiveness to the upper layer resist film, the adhesive film capable of effectively controlling pattern collapse and at the same time contributing to sensitivity enhancement of the upper layer resist while keeping LWR thereof.

Additionally, the heterocyclic structure of R₂ in the formulae (1) and (2) preferably contains an oxygen atom.

By using such composition for forming an adhesive film, it is possible to enhance adhesiveness to a resist pattern and prevent collapse of a fine pattern.

Additionally, R₂ in the formulae (1) and (2) preferably represents a monovalent organic group containing a group selected from the following formulae (R₂-1) to (R₂-3), 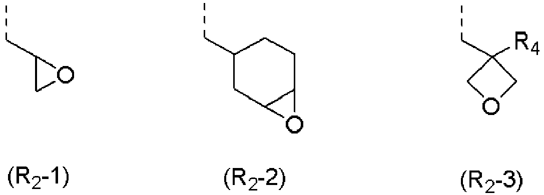 wherein R₄ represents a hydrogen atom or an alkyl group having 1 to 10 carbon atoms; and a broken line represents a bonding arm.

Additionally, the organic polymer (A) is preferably a polymer compound further containing any of repeating units represented by the following formula (3a) or (3b), 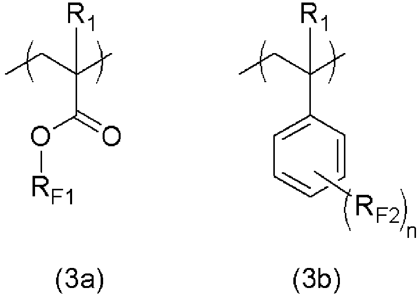 wherein R_{F1} represents a monovalent organic group having 1 to 20 carbon atoms and containing at least one F atom; R_{F2} represents a F atom or a monovalent organic group having 1 to 10 carbon atoms and containing one or more F atoms; R₁ is the same as defined in the above formula (1); and "n" represents 1 to 5.

It is more preferable to contain such repeating units such that the organic polymer excellent in adhesiveness is more easily localized on the surface layer of the adhesive film.

Additionally, the organic polymer (A) is preferably a polymer compound having a weight average molecular weight of 6,000 to 50,000.

Additionally, the organic polymer (A) is preferably a polymer compound having a dispersity of 3.0 or less determined by weight average molecular weight/number average molecular weight.

By setting the weight average molecular weight and/or the dispersity of the polymer compound contained in the composition for forming an adhesive film within such ranges, it is possible to obtain excellent film formability, and further reduce generation of sublimates during heat curing, thereby preventing contamination of an apparatus.

Additionally, the metal source (B) is preferably a salt of the metal with a monovalent to tetravalent carboxylic acid having 1 to 30 carbon atoms.

Such composition for forming an adhesive film enables to form an adhesive film capable of contributing to sensitivity enhancement while keeping LWR of the upper layer resist.

Additionally, the metal source (B) preferably has a structure represented by the following formula (B-1), 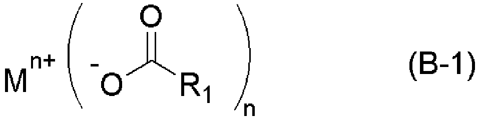 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.

Such composition for forming an adhesive film enables to form an adhesive film capable of contributing to sensitivity enhancement while keeping LWR of the upper layer resist.

In this case, R₁ in the formula (B-1) preferably represents a saturated or unsaturated hydrocarbon group having 1 to 10 carbon atoms.

When such metal source (B) is used in the composition for forming an adhesive film, favorable solubility in an organic solvent can be achieved, and an adhesive film with excellent film formability and fewer defects can be formed.

In this case, R₁ in the formula (B-1) preferably represents a branched alkyl group having 3 to 10 carbon atoms.

When such metal source (B) is used in the composition for forming an adhesive film, favorable solubility in an organic solvent can be achieved, and an adhesive film with excellent film formability and fewer defects can be formed.

Additionally, the metal of the metal source (B) is preferably Sn.

Such composition for forming an adhesive film enables to form an adhesive film capable of contributing to sensitivity enhancement while keeping LWR of the upper layer resist.

Furthermore, the composition for forming an adhesive film of the present invention preferably contains at least one or more of (D) a thermal acid generator, (E) a photoacid generator, (F) a crosslinking agent, and (G) a surfactant.

Depending on presence or absence and selection of these various additives, it is possible to finely adjust performances such as film formability, reduction of sublimates, and further various properties in resist patterning according to customer demands, thereby providing practical advantages.

The organic solvent (C) is preferably a mixture of one or more kinds of organic solvents having a boiling point of less than 180°C and one or more kinds of organic solvents having a boiling point of 180°C or higher ((C-1) a high-boiling-point solvent).

By containing such high-boiling-point solvent, it is possible to obtain sufficient thermal flowability during film formation, thereby achieving both of adhesiveness of the organic polymer (A) to the pattern and etch selectivity of the metal source (B) at a high level with no formation of a sea-island structure during forming the adhesive film.

Furthermore, the present invention provides a patterning process for forming a pattern in a substrate to be processed, including steps of:
(I-1) forming a resist underlayer film on the substrate to be processed;
(I-2) forming a silicon-containing resist middle layer film on the resist underlayer film;
(I-3) applying the above composition for forming an adhesive film on the silicon-containing resist middle layer film and thereafter performing heat treatment to form an adhesive film;
(I-4) forming a resist upper layer film on the adhesive film using a photoresist material;
(I-5) forming a pattern in the resist upper layer film by developing the resist upper layer film using a developer after pattern exposure;
(I-6) transferring the pattern to the adhesive film by dry etching while using the resist upper layer film having the formed pattern as a mask;
(I-7) transferring the pattern to the silicon-containing resist middle layer film by dry etching while using the adhesive film having the formed pattern as a mask;
(I-8) transferring the pattern to the resist underlayer film by dry etching while using the silicon-containing resist middle layer film having the transferred pattern as a mask; and
(I-9) transferring the pattern to the substrate to be processed by dry etching while using the resist underlayer film having the transferred pattern as a mask.

The patterning process with the above four-layer resist process is capable of forming a fine pattern in a workpiece (substrate to be processed).

Furthermore, the present invention provides a patterning process for forming a pattern in a substrate to be processed, including steps of:
(II-1) forming a resist underlayer film on the substrate to be processed;
(II-2) forming an inorganic hard mask middle layer film selected from a silicon oxide film, a silicon nitride film, and a silicon oxynitride film on the resist underlayer film;
(II-3) applying the above composition for forming an adhesive film on the inorganic hard mask middle layer film and thereafter performing heat treatment to form an adhesive film;
(II-4) forming a resist upper layer film on the adhesive film using a photoresist material;
(II-5) forming a pattern in the resist upper layer film by developing the resist upper layer film using a developer after pattern exposure;
(II-6) transferring the pattern to the adhesive film by dry etching while using the resist upper layer film having the formed pattern as a mask;
(II-7) transferring the pattern to the inorganic hard mask middle layer film by dry etching while using the adhesive film having the formed pattern as a mask;
(II-8) transferring the pattern to the resist underlayer film by dry etching while using the inorganic hard mask middle layer film having the transferred pattern as a mask; and
(II-9) transferring the pattern to the substrate to be processed by dry etching while using the resist underlayer film having the transferred pattern as a mask.

The patterning process with the above four-layer resist process is capable of forming a fine pattern in a workpiece with high precision.

Additionally, the pattern exposure is preferably performed using EUV light in the step (I-5).

Additionally, the pattern exposure is preferably performed using EUV light in the step (II-5).

The composition for forming an adhesive film of the present invention contains a metal atom with high optical absorption, thereby enabling formation of an adhesive film capable of contributing to sensitivity enhancement while keeping LWR of the upper layer resist by EUV lithography. Furthermore, the composition contains the organic polymer excellent in adhesiveness to the resist upper layer film, such that pattern collapse can effectively be controlled. Therefore, the composition is suitable for photolithography of the resist upper layer film, and also enables to transfer the resist upper layer film pattern to the substrate to be processed with high precision.

### ADVANTAGEOUS EFFECTS OF INVENTION

As described above, the present invention provides a composition for forming an adhesive film that has high adhesiveness to a resist upper layer film and a prevention effect on collapse of a fine pattern, and is also capable of contributing to sensitivity enhancement while keeping LWR of an upper layer resist in EUV lithography. Additionally, this composition for forming an adhesive film is extremely useful for a multilayer resist process, because it has high adhesiveness and a prevention effect on collapse of a fine pattern, and provides the substrate to be processed with a highly rectangular pattern profile of the resist upper layer film.

### BRIEF DESCRIPTION OF DRAWINGS

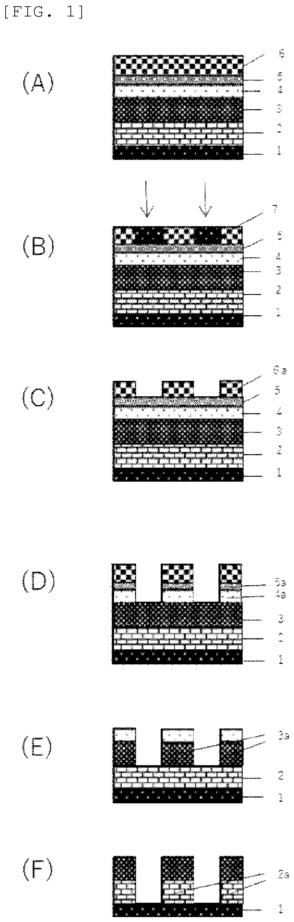

FIG. 1 is a diagram illustrating a patterning process according to an embodiment of the present invention (four-layer resist process).

### DESCRIPTION OF EMBODIMENTS

As described above, it has been demanded to develop: a composition for forming an adhesive film, the composition capable of yielding an adhesive film with high adhesiveness to a resist upper layer film to control collapse of a fine pattern in a fine patterning process during semiconductor apparatus manufacturing processes, and also capable of contributing to sensitivity enhancement while keeping LWR in EUV lithography; and a patterning process using the composition.

As a result of intensive investigation on the above problems, the present inventors have found that the above problems can be solved by a composition for forming an adhesive film, the composition containing a polymer compound having a specific structure and a metal source, and a patterning process using this composition for forming an adhesive film, and completed the present invention.

Thus, the present invention is a composition for forming an adhesive film that is formed between a silicon-containing middle layer film and a resist upper layer film. The composition contains (A) an organic polymer, (B) a metal source, and (C) an organic solvent. The organic polymer (A) is a polymer compound containing one or both of repeating units represented by the following formulae (1) and (2), and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 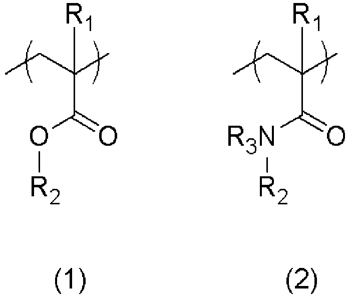 wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.

Hereinafter, the present invention will be described in detail. However, the present invention is not limited thereto.

### <Composition for Forming Adhesive Film>

The present invention is a composition for forming an adhesive film that is formed between a silicon-containing middle layer film and a resist upper layer film. The composition contains (A) an organic polymer, (B) a metal source, and (C) an organic solvent. The organic polymer (A) is a polymer compound containing one or both of repeating units represented by the following formulae (1) and (2), and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 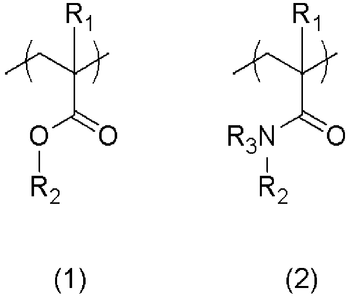 wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.

Such composition for forming an adhesive film can provide an adhesive film with a high metal content, because the metal salt structure is decomposed by heat treatment to cause metal ion desorption, thereby forming a metal oxide. Since the film contains a large number of metal atoms with high optical absorption, it has a feature that a sensitizing effect can be expected due to secondary electrons generated from these metal atoms during exposure in EUV lithography. Furthermore, since the above metal atom has a large atomic weight, it has features of a high suppression effect on acid diffusion from the upper layer resist into the adhesive film, and ability to increase sensitivity while maintaining the inherent LWR performance of the resist upper layer film. Additionally, the composition for forming an adhesive film contains the organic polymer containing any of the repeating units represented by the formula (1) or (2) and having excellent adhesiveness to the resist upper layer film pattern, and thus it is effective in controlling collapse of a fine pattern and can provide a very effective patterning process for lithography using EUV light.

Note that in the composition for forming an adhesive film of the present invention, one component alone or two or more components in combination can be respectively used as the organic polymer (A), the metal source (B), and the organic solvent (C). Furthermore, the above composition for forming an adhesive film may contain other components in addition to the above components (A), (B), and (C). Each component will be described below.

### (A) Organic Polymer

The organic polymer (A) contained in the composition for forming an adhesive film of the present invention is a polymer compound containing one or both of repeating units represented by the following general formulae (1) and (2). 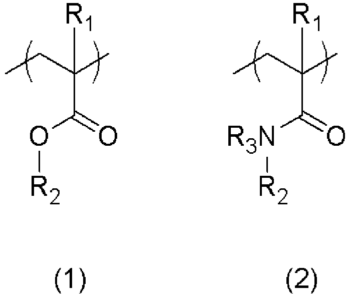 (In the formulae, R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.)

Such organic polymer (A) has a low surface energy as compared with the metal source (B), thereby achieving both of adhesiveness of the organic polymer (A) to the pattern and etch selectivity of the metal source (B) at a high level with no formation of a sea-island structure during forming the adhesive film.

The above R₃ preferably represents a hydrogen atom.

The heterocyclic structure contained in R₂ of the repeating units represented by the above general formulae (1) and (2) preferably contains an oxygen atom.

By containing such heterocyclic structure, higher adhesiveness to the resist pattern can be obtained, that is more effective in preventing collapse of a fine resist pattern.

The R₂ preferably represents a monovalent organic group containing a group selected from the following formulae (R₂-1) to (R₂-3). 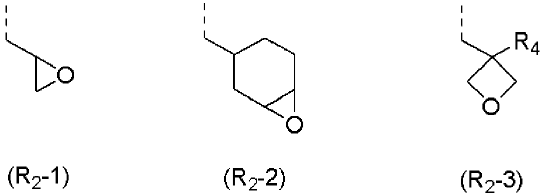 (In the formulae, R₄ represents a hydrogen atom or an alkyl group having 1 to 10 carbon atoms; and a broken line represents a bonding arm.)

By containing such heterocyclic structure, an epoxy or oxetane structure undergoes a ring opening reaction during heating film formation to cure a film. Additionally, a hydroxyl group generated by this ring opening reaction also contributes to enhancing adhesiveness to the resist upper layer film.

R₄ in the above (R₂-3) preferably represents a hydrogen atom, a methyl group, or an ethyl group, and more preferably represents an ethyl group.

Specific examples of the repeating units represented by the above formulae (1) and (2) preferably include the following structures. 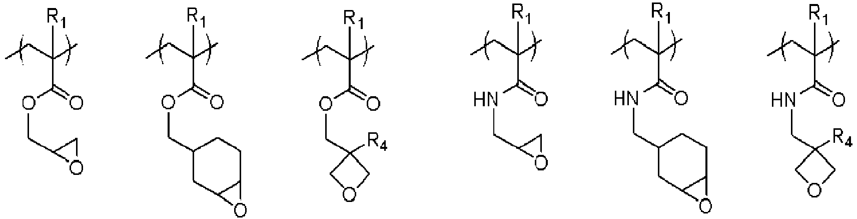 (R₁ and R₄ are as defined above.)

Note that only one or two or more of the repeating units represented by the above general formulae (1) and (2) may be contained in the polymer compound of the organic polymer (A).

The polymer compound contained in the above organic polymer (A) contains the repeating units represented by the above general formulae (1) and (2) in an amount of preferably 5 mol% or more, more preferably 10 mol% or more, and further preferably 20 mol% or more relative to the whole repeating units.

Additionally, the polymer compound contained in the above organic polymer (A) contains the repeating units represented by the above general formulae (1) and (2) in an amount of preferably 95 mol% or less and more preferably 90 mol% or less relative to the whole repeating units.

Such amount percentage of the repeating units represented by the above general formulae (1) and (2) leads to adjusted polarity of the polymer compound, and thus favorable adhesiveness to the resist pattern. Furthermore, the epoxy or oxetane structure in the above general formulae (1) and (2) undergoes a ring opening reaction during heating film formation to cure a film, thereby enabling to form an elaborate adhesive film and prevent intermixing between the adhesive film and the resist upper layer film. This can prevent generation of residues in space portions of the pattern and yield a highly rectangular pattern. Accordingly, the above organic polymer (A) preferably contains the repeating units represented by the above general formulae (1) and (2) in an amount of 30 mol% or more and 95 mol% or less, particularly 50 mol% or more and 90 mol% or less, relative to the whole repeating units.

The organic polymer (A) is preferably a polymer compound further containing any of repeating units represented by the following formula (3a) or (3b). 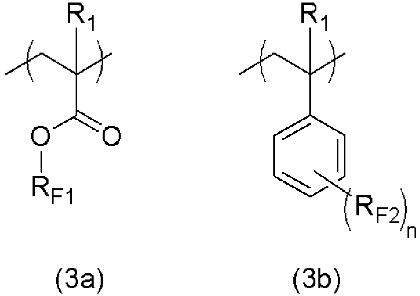 (In the formulae, R_{F1} represents a monovalent organic group having 1 to 20 carbon atoms and containing at least one F atom; R_{F2} represents a F atom or a monovalent organic group having 1 to 10 carbon atoms and containing one or more F atoms; R₁ is the same as defined in the above formula (1); and "n" represents 1 to 5.)

It is more preferable that the polymer compound contains any of the repeating units represented by the formula (3a) or (3b) such that the organic polymer (A) is more easily localized on the surface layer of the adhesive film.

Specific examples of the repeating units represented by the formulae (3a) and (3b) preferably include the following structures. 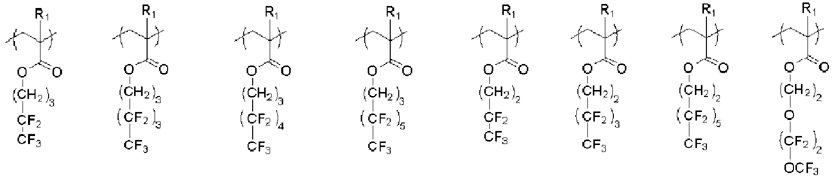 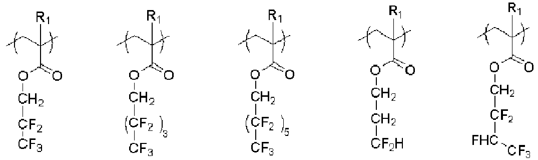 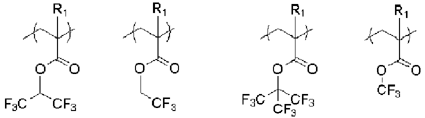 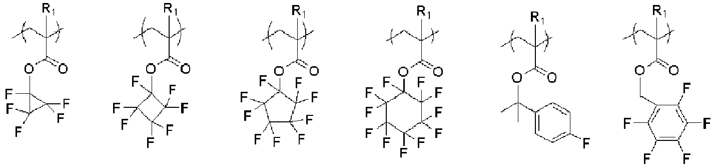 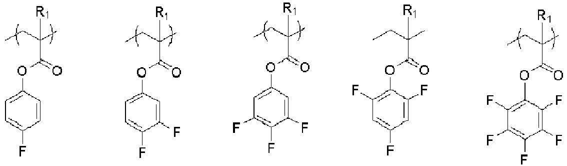 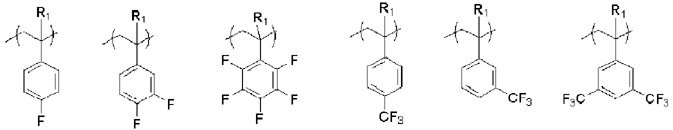 (R₁ is as defined above.)

Note that only one or two or more of the repeating units represented by the above general formulae (3a) and (3b) may be contained in the organic polymer (A).

The polymer compound as the above organic polymer (A) contains the repeating units represented by the above general formulae (1) and (2) in an amount of 30 mol% or more and 95 mol% or less, more preferably 50 mol% or more and 90 mol% or less, relative to the whole repeating units. The amount percentage of the repeating units represented by the above general formulae (3a) and (3b) is 5 mol% or more and 70 mol% or less, more preferably 10 mol% or more and 50 mol% or less.

The organic polymer (A) is preferably a polymer compound further containing any repeating unit represented by the following formula (4a). 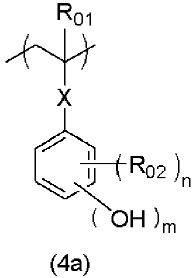 (In the formula, R₀₁ represents a hydrogen atom or a methyl group; R₀₂ represents an alkyl group having 1 to 3 carbon atoms; "m" represents an integer of 1 or 2, "n" represents an integer of 0 to 4, and m+n equals an integer of 1 or more and 5 or less; and X represents a single bond or an alkylene group having 1 to 10 carbon atoms and optionally containing an oxygen atom.)

R₀₁ in the general formula (4a) represents a hydrogen atom or a methyl group. R₀₂ represents an alkyl group having 1 to 3 carbon atoms. "m" represents an integer of 1 or 2, "n" represents an integer of 0 to 4, and m+n equals an integer of 1 or more and 5 or less. Preferably, "m" represents an integer of 1 or 2, "n" represents an integer of 0 or 1, and m+n equals an integer of 1 or more and 3 or less, and further preferably, "m" represents 1, "n" represents 0, and m+n equals 1.

X in the general formula (4a) represents a single bond or an alkylene group having 1 to 10 carbon atoms and optionally containing an oxygen atom. The oxygen atom in the X can form a carbonyl group, a hydroxyl group, or an ether bond. For example, an ester bond is an alkylene group having 1 carbon atom and containing an oxygen atom.

Specific examples of the X are illustrated below, but not limited thereto. 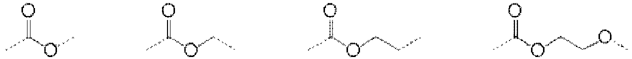 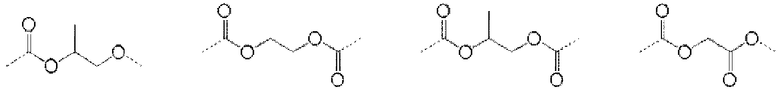 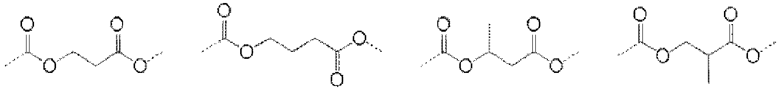 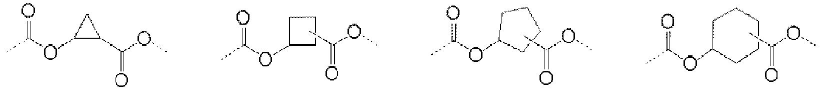 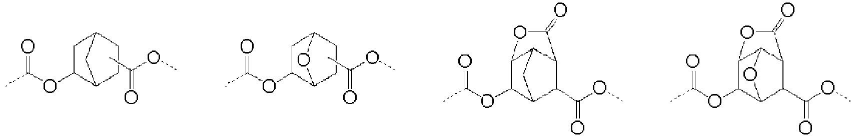 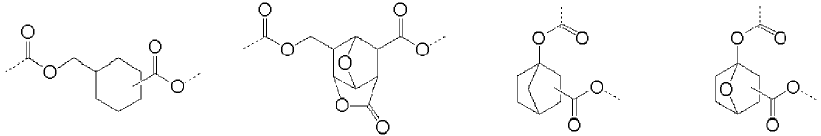 (In the formulae, a broken line represents a bonding arm.)

Examples of R₀₂ in the general formula (4a) include methyl group, ethyl group, propyl group, and isopropyl group. Preferred is a methyl group from the viewpoint of adhesiveness to the resist upper layer film.

Examples of a resin represented by the general formula (4a) are specifically illustrated below, but not limited thereto. R₀₁ in the following formulae is as defined above.

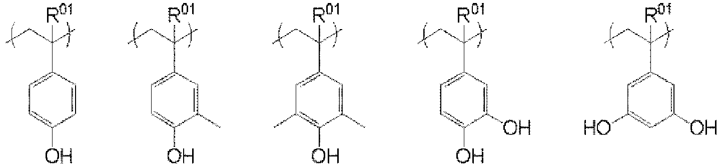

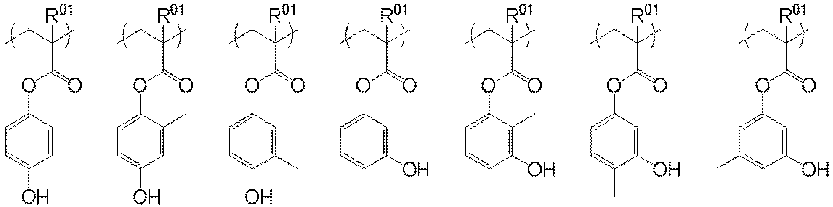

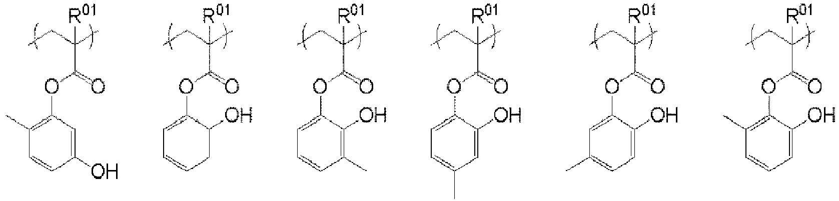

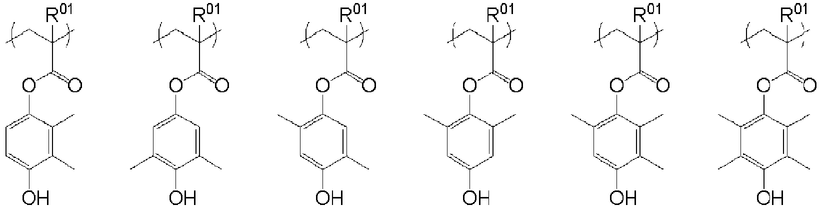

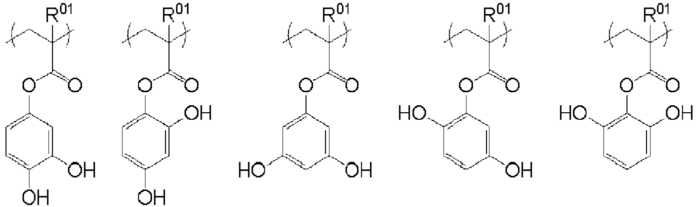

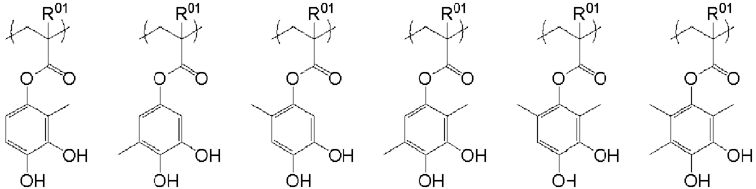

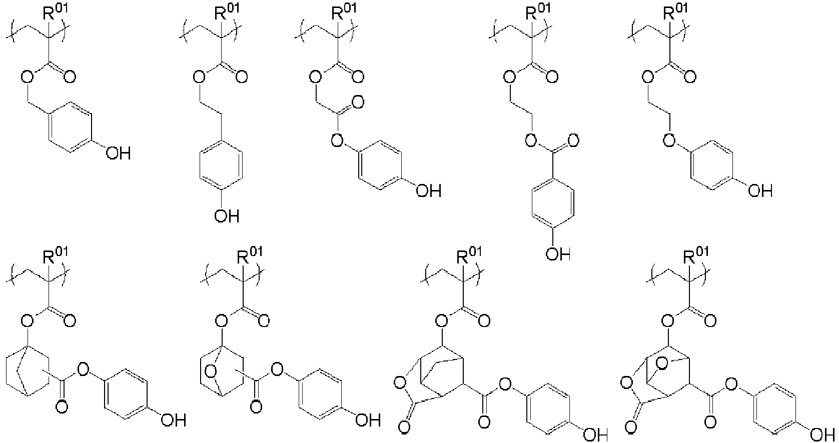

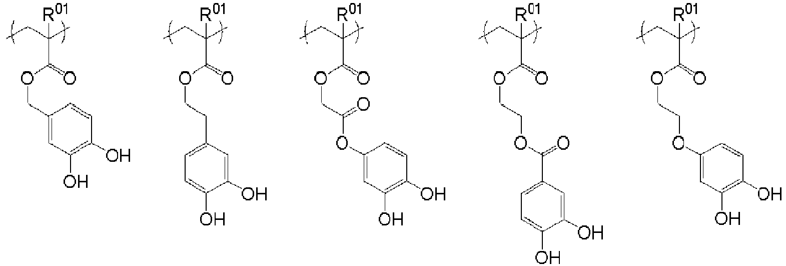

The composition for forming an adhesive film contains these resins such that an adhesive film with excellent film formability can be formed on a silicon-containing resist middle layer film.

Furthermore, the above organic polymer (A) preferably further contains a repeating unit represented by the following general formula (A-1). 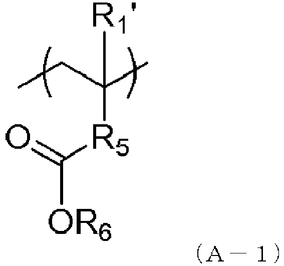 (In the formula, R₁' represents a hydrogen atom or a methyl group; R₅ represents a single bond or a divalent linking group having 2 to 10 carbon atoms and containing an ester group; and R₆ represents a saturated or unsaturated tertiary alkyl group having 4 to 20 carbon atoms.)

In the above general formula (A-1), R₅ represents a single bond or a divalent linking group having 2 to 10 carbon atoms and containing an ester group. Specific examples of R₅ include a single bond, -CO₂CH₂-, - CO₂CH₂CH₂-, -CO₂CH₂CH₂CH₂-, -CO₂CH(CH₃)-, -CO₂CH₂CH₂CH₂CH₂-, -CO₂CH₂CH₂CH₂CH₂CH₂-, -CO₂CH₂CH₂CH₂CH₂CH₂CH₂CH₂CH₂-, - CO₂CH₂CH₂O-, -CO₂CH₂CH₂OCH₂CH₂O-, -CO₂CH₂CH₂OCH₂CH₂OCH₂CH₂O-, and the like. Among these, particularly preferred are - CO₂CH₂-, -CO₂CH₂CH₂-, -CO₂CH₂CH₂CH₂-, -CO₂CH₂CH₂CH₂CH₂-, and -CO₂CH₂CH₂CH₂CH₂CH₂- .

Specific examples of R₆ in the repeating unit represented by the above general formula (A-1) include structures shown below, but are not limited thereto. A broken line represents a bonding arm.

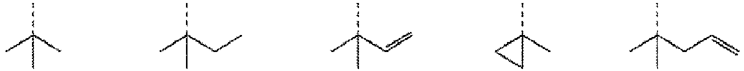

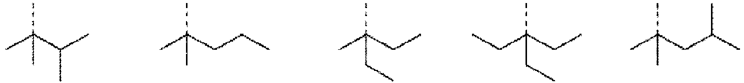

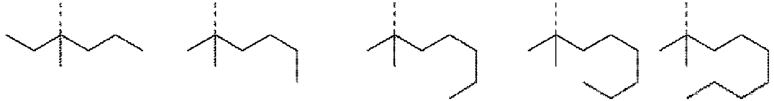

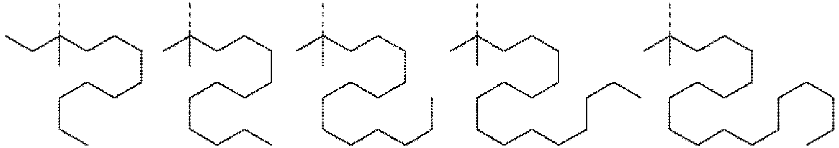

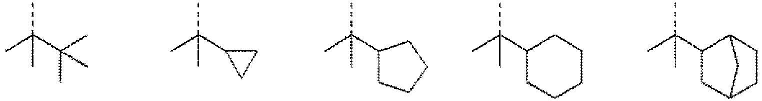

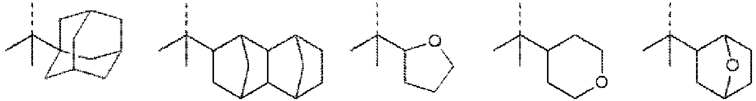

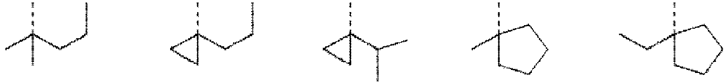

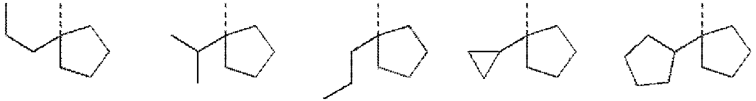

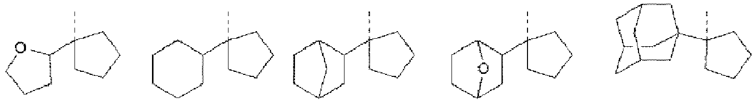

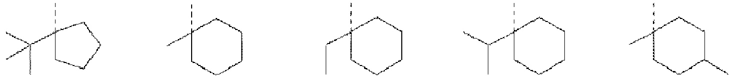

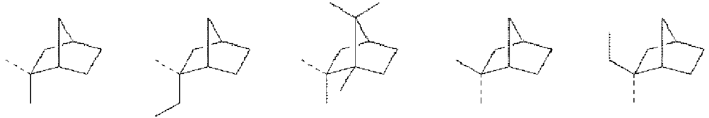

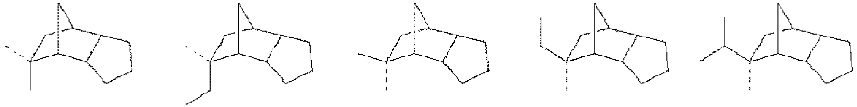

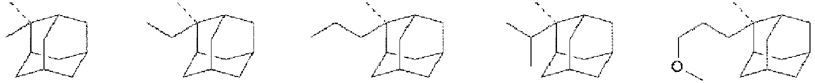

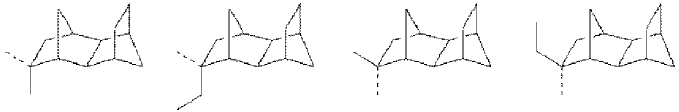

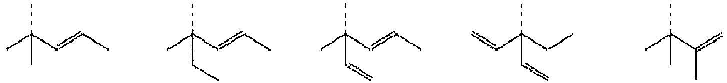

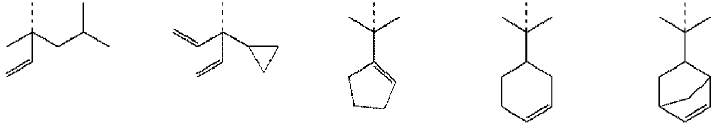

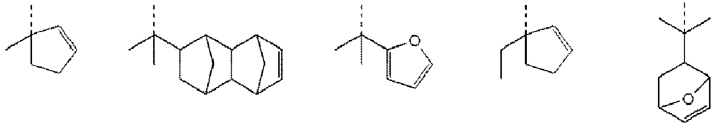

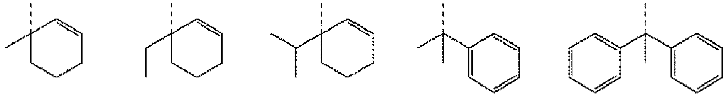

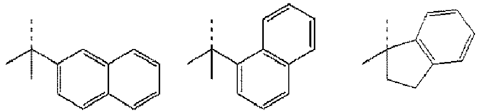

When an adhesive film is formed from the composition for forming an adhesive film that contains the polymer compound containing the repeating unit represented by the above general formula (A-1), elimination and decomposition reaction of the tertiary alkyl group R₆ proceeds due to heat and/or action of acid generated by an acid generator as described later, thereby generating carboxylic acid. The polarity of this carboxylic acid improves adhesiveness to the resist pattern, improves rectangularity of the pattern, and prevents generation of residues in pattern space portions.

Furthermore, this generated carboxylic acid may undergo a ring-opening addition reaction with the repeating units represented by the above general formulae (1) and (2) to form a hydroxyester crosslinking structure. A typical example of the reaction is shown below. In the following formulae, (A-2) represents a state where the carboxylic acid is formed by the elimination of R₆ in the repeating unit (A-1), and (A-3) represents a state where the hydroxyester crosslinking structure is formed by the ring-opening addition reaction with (1") as one example of the above general formulae (1) and (2). Additionally, the portion surrounded by the broken line represents the hydroxyester crosslinking structure formed by this reaction. 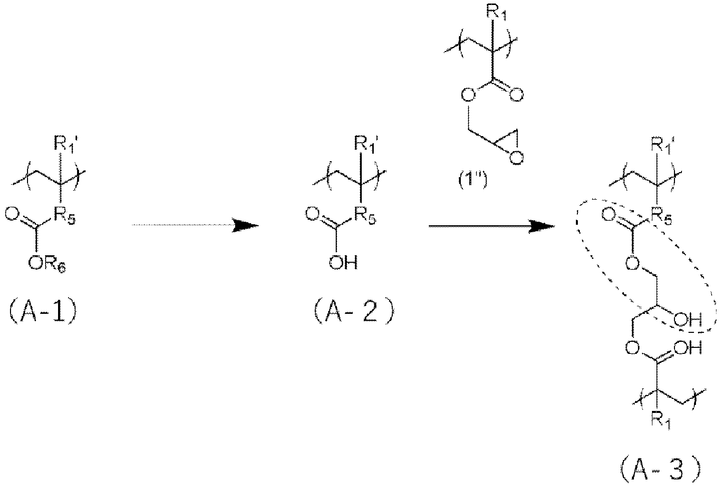 (In the formulae, R¹, R⁵, R⁶, and R¹' are as defined above.)

The formation of this hydroxyester crosslinking structure is a crosslinking reaction, which facilitates curing of the adhesive film. Sufficient curing results in formation of an elaborate film and prevents intermixing between the adhesive film and the resist upper layer film, which in turn can prevent the generation of residues in the pattern space portions and yield a highly rectangular pattern.

Furthermore, the above hydroxyester crosslinking structure is a polar group and interacts with the resist pattern. Therefore, the presence of the repeating unit (A-1) also contributes to preventing collapse of the resist pattern.

Note that only one or two or more of the repeating unit represented by the above general formula (A-1) may be contained in the polymer compound of the organic polymer (A).

When the polymer compound of the above organic polymer (A) contains the repeating unit represented by the above formula (A-1), the amount percentage of the repeating unit represented by the formula (A-1) is preferably 1 mol% or more and 30 mol% or less, or preferably 5 mol% or more and 15 mol% or less, relative to the whole repeating units in the polymer compound of the above organic polymer (A).

The above organic polymer (A) preferably has a weight average molecular weight of 6,000 to 50,000, and a dispersity of 3.0 or less determined by weight average molecular weight/number average molecular weight.

Note that the "weight average molecular weight" as described herein is a value measured by gel permeation chromatography (GPC) in terms of polystyrene using tetrahydrofuran as a solvent. When the weight average molecular weight and the dispersity of the polymer compound used in the organic polymer (A) contained in the composition for forming an adhesive film fall within these ranges, excellent film formability can be obtained upon performing spin coating and generation of sublimates during heat curing can be reduced to prevent contamination of an apparatus. Particularly, when the adhesive film is formed as the resist middle layer film, a volatile low-molecular-weight component contained in the composition tends to cause variation in film thickness distribution in a plane of a substrate to be processed. However, by setting the molecular weight and the dispersity of the polymer compound to be used as described above to control the amount of the low-molecular-weight component in the composition, it is possible to minimize the film thickness distribution in the plane of the substrate to be processed. Accordingly, the weight average molecular weight of the polymer compound contained in the organic polymer (A) used in the composition for forming an adhesive film of the present invention is preferably 6,000 to 50,000, particularly preferably 8,000 to 40,000. The dispersity is preferably 3.0 or less.

The amount of the organic polymer (A) in the composition for forming an adhesive film is preferably 1 parts by mass or more and 50 parts by mass or less, more preferably 5 parts by mass or more and 30 parts by mass or less relative to 100 parts by mass of the metal source (B).

Such amount enables to achieve both of adhesiveness of the organic polymer (A) to the pattern and etch selectivity of the metal source (B) at the even higher level.

In an example method for synthesizing the polymer compound of the organic polymer (A), monomers having a polymerizable unsaturated bond corresponding to the respective repeating units are mixed and a radical polymerization initiator is added to perform thermal polymerization in a solvent.

Various polymerization conditions can be selected according to the monomers to be used, target molecular weight, etc., and are not particularly limited. Specific examples of the solvent to be used during the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, butyl acetate, diacetone alcohol, and the like. Examples of the radical polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, lauroyl peroxide, and the like. Additionally, thiols such as octanethiol and 2-mercaptoethanol may be added as a chain transfer agent during the polymerization. The polymerization reaction can be performed by heating, preferably to a range from 40°C to the boiling point of the reaction solvent. The reaction time is preferably 0.5 to 100 hours, more preferably 1 to 48 hours.

For example, compounds having a polymerizable double bond represented by the following general formulae (1'), (2'), and (A-1') can be used as the monomers to perform the polymerization as described above, thereby synthesizing the polymer compound containing the repeating units represented by the above general formulae (1), (2), and (A-1). 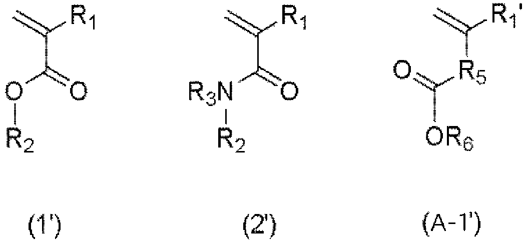 (In the formulae, R₁ to R₃, R₅ to R₆, and R₁' are as defined above.)

Upon polymerization, all the raw materials may be mixed and thereafter heated, or some of the raw materials may be heated in advance and then the rest of the raw materials may be added thereto individually or in a mixed state, all at once or gradually. For example, a polymerization method in which only a polymerization solvent is heated and then a monomer solution and a polymerization initiator solution are separately and gradually added thereto is particularly preferred, because it can yield a relatively homogeneous polymer compound and also prevent abnormal reactions such as a runaway reaction.

The polymer compound solution obtained in the above manner may be directly blended with the composition for forming an adhesive film, or may be purified by any usual method such as crystallization, liquid separation, filtration, or concentration as necessary to remove residual monomers, residual solvents, reaction byproducts, and other impurities. In the case of purifying the polymer compound, preferred is a crystallization method, in which a poor solvent such as water, a water-containing alcohol, or a saturated hydrocarbon is added to the polymer compound solution to collect the precipitation by filtration, or a liquid separation method, in which a poor solvent layer is separated and removed. Of these methods, the liquid separation method is particularly preferred. Purification of the polymer compound by the liquid separation method can efficiently remove the low-molecular-weight component in the polymer compound solution and thus reduce generation of sublimates during forming an adhesive film from the composition for forming an adhesive film containing this polymer compound. As a result, contamination of a deposition apparatus can be prevented.

### <(B) Metal Source>

The metal source (B) contained in the composition for forming an adhesive film of the present invention is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Preferred examples of the carboxylic acid salt are illustrated below.

| | | | | |
|---|---|---|---|---|
| Ti⁴⁺(R¹COO⁻)₄ | Ti⁴⁺(R²(COO⁻)₂)₂ | Ti⁴⁺R⁴(COO⁻)₄ | | |
| Cr²⁺(R¹COO⁻)₂ | Cr²⁺R²(COO⁻)₂ | | | |
| Cr³⁺(R¹COO⁻)₃ | (Cr³⁺)₂(R²(COO⁻)₂)₃ | Cr³⁺(R¹COO⁻)(OH)₂ | (Cr³⁺)₂(R³(COO⁻)₃)₂ | |
| Mn²⁺(R¹COO⁻)₂ | Mn²⁺R²(COO⁻)₂ | Mn³⁺(R¹COO⁻)₃ | Mn³⁺)₂(R²(COO⁻)₂)₃ | |
| Fe²⁺R²(COO⁻)₂ | Fe³⁺(R¹COO⁻)₃ | (Fe³⁺)₂(R²(COO⁻)₂)₃ | Fe³⁺R³(COO⁻)₃ | Fe²⁺(R¹COO⁻)₂ |
| Co²⁺(R¹COO⁻)₂ | Co²⁺R²(COO⁻)₂ | | | |
| Ni²⁺(R¹COO⁻)₂ | Ni²⁺R²(COO⁻)₂ | | | |
| Cu⁺R¹COO⁻ | (Cu⁺)₂R²(COO⁻)₂ | Cu²⁺(R¹COO⁻)₂ | Cu²⁺R²(COO⁻)₂ | |
| Zn⁺R¹COO⁻ | (Zn⁺)₂R²(COO⁻)₂ | Zn²⁺(R¹COO⁻)₂ | | |
| Zr⁴⁺(R¹COO⁻)₄ | Zr⁴⁺(R²(COO⁻₂)₂ | Zr⁴⁺R⁴(COO⁻)₄ | | |
| Mo⁴⁺(R¹COO⁻)₄ | | | | |
| In³⁺(R¹COO⁻)₃ | (In³⁺)₂(R²(COO⁻)₂)₃ | In³⁺R³(COO⁻)₃ | | |
| Sn²⁺(R¹COO⁻)₂ | Sn²⁺R²(COO⁻)₂ | Sn⁴⁺(R¹COO⁻)₄ | Sn⁴⁺(R²(COO⁻)₂)₂ | Sn⁴⁺R⁴(COO⁻)₄ |
| Hf⁴⁺(R¹COO⁻)₄ | Hf⁴⁺(R²(COO⁻)₂)₂ | Hf⁴⁺R⁴(COO⁻)₄ | | |
| Bi³⁺(R¹COO⁻)₃ | (Bi³⁺)₂(R²(COO⁻)₂)₃ | Bi³⁺R³(COO⁻)₃ | | |

(In the formulae, R¹ may be identical to or different from each other, and represents hydrogen atom, linear, branched, or cyclic alkyl group having 1 to 30 carbon atoms, preferably 1 to 20 carbon atoms, alkenyl group having 2 to 30 carbon atoms, preferably 2 to 20 carbon atoms, alkynyl group having 2 to 30 carbon atoms, preferably 2 to 20 carbon atoms, or aryl group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R² represents a single bond, or a linear, branched, or cyclic alkylene group, alkenylene group, or alkynylene group each having 1 to 30 carbon atoms, preferably 1 to 20 carbon atoms, or an arylene group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R³ represents a group obtained by removing one hydrogen atom from the alkylene group, arylene group, alkenylene group, or alkynylene group of the R²; and R⁴ represents a group obtained by removing two hydrogen atoms from the alkylene group, arylene group, alkenylene group, or alkynylene group of the R².)

Specific examples of carboxylic acid ions for forming the carboxylic acid salt in the above general formulae are illustrated below.

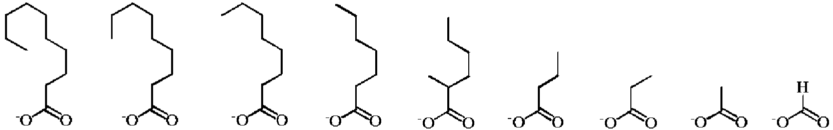

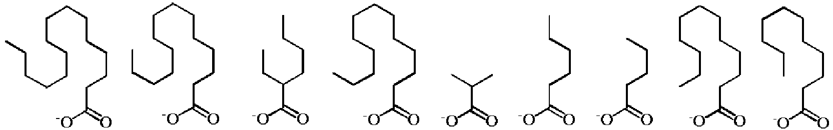

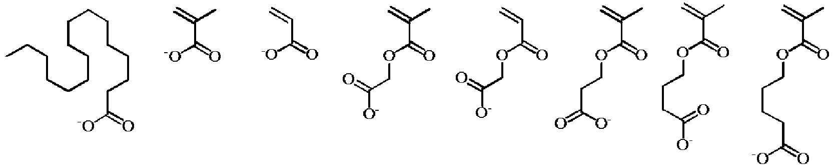

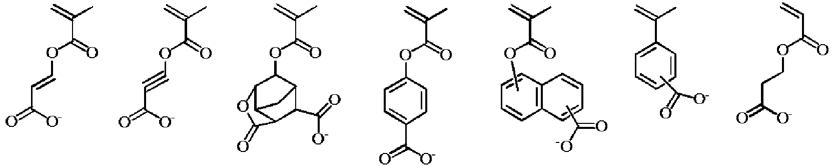

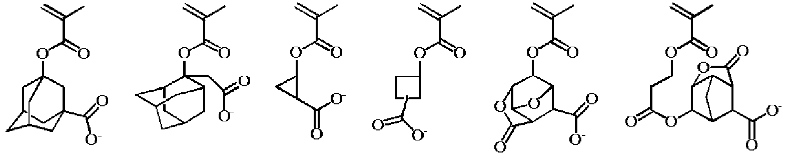

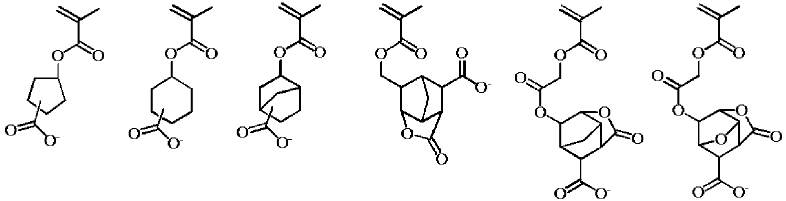

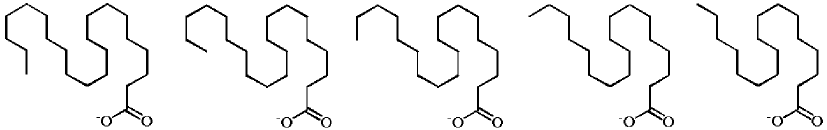

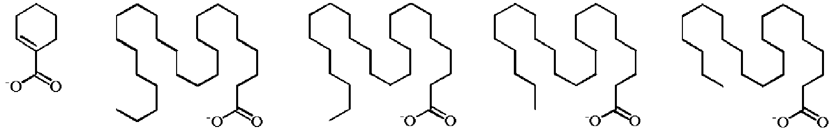

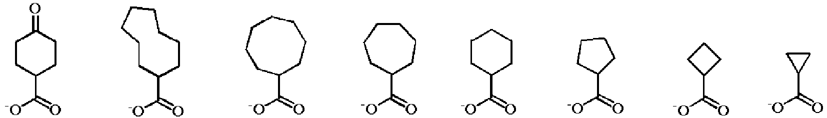

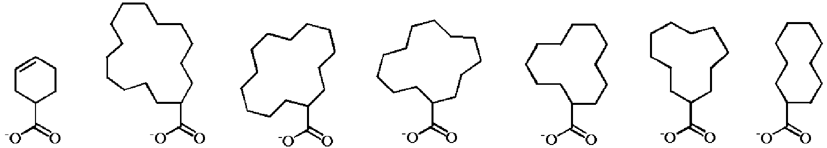

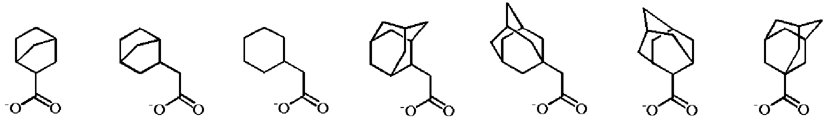

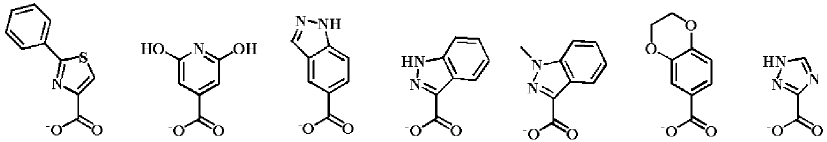

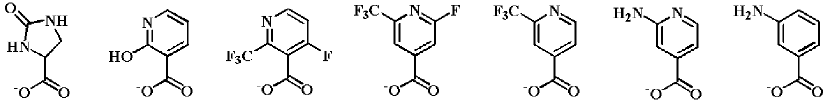

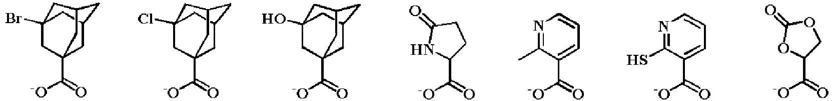

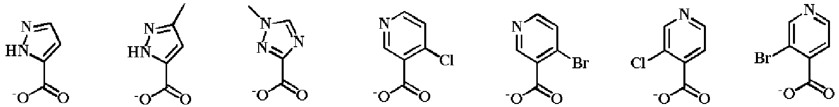

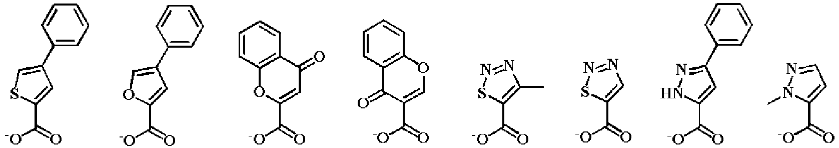

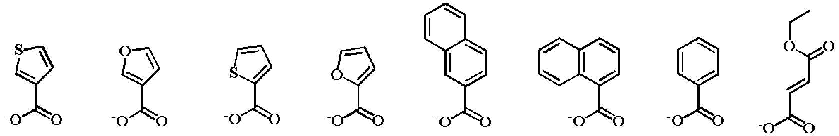

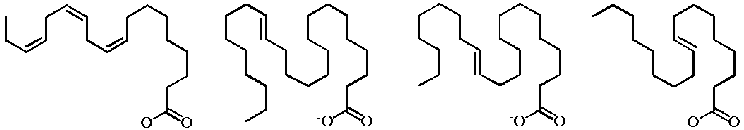

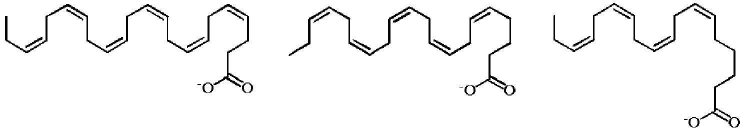

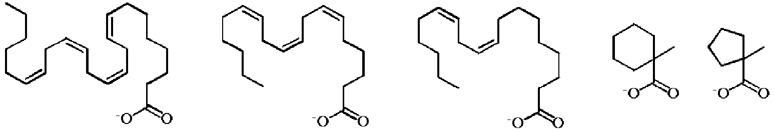

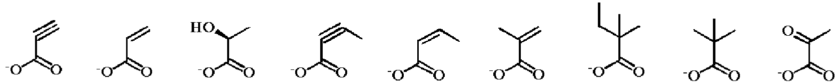

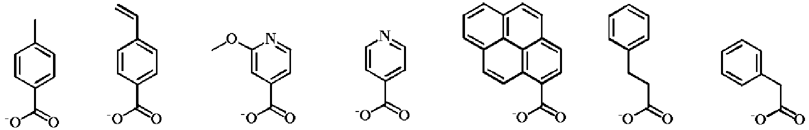

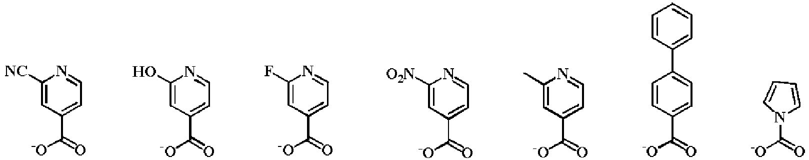

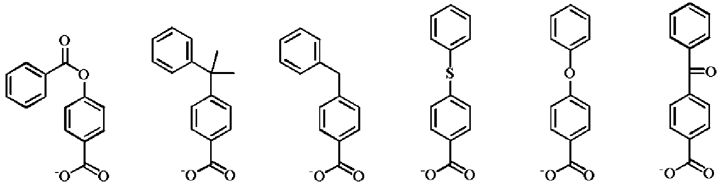

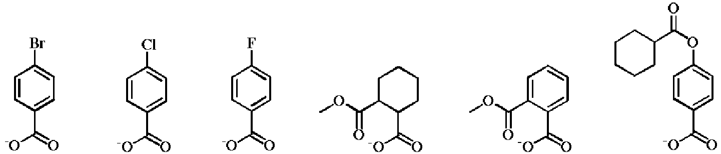

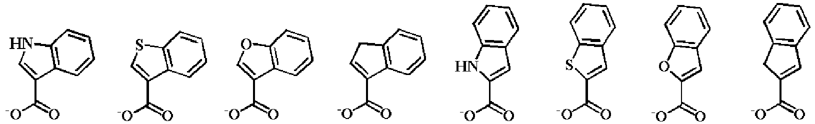

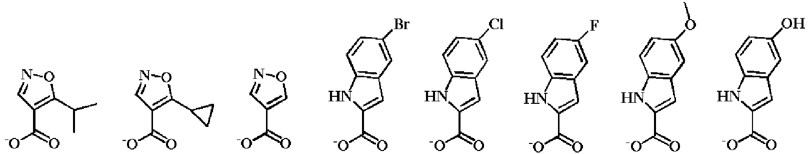

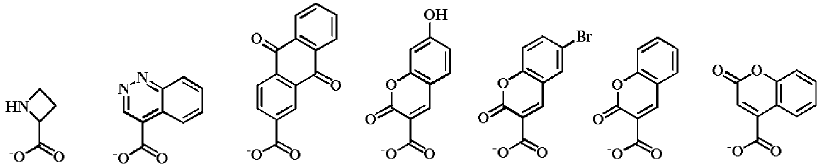

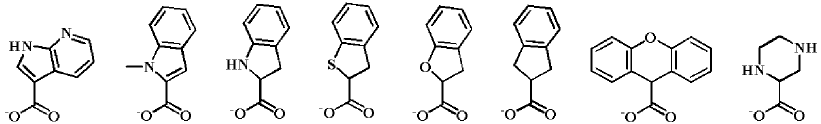

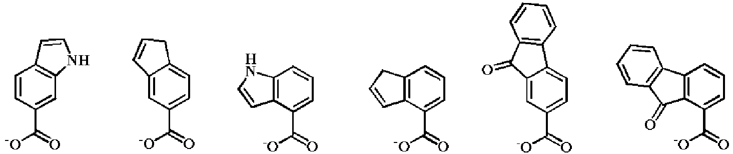

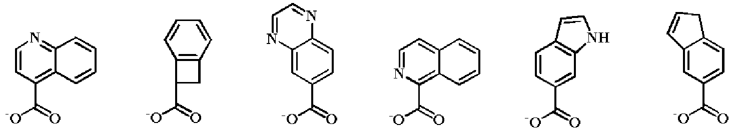

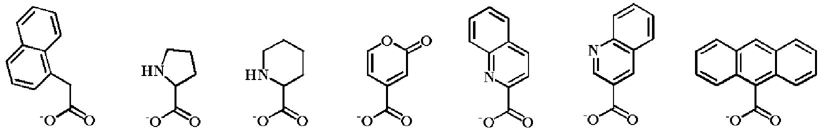

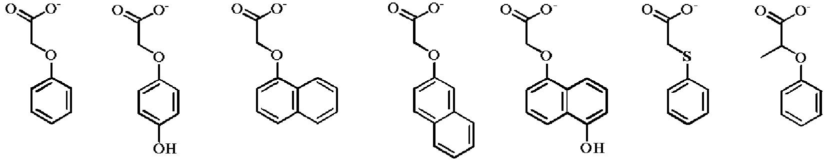

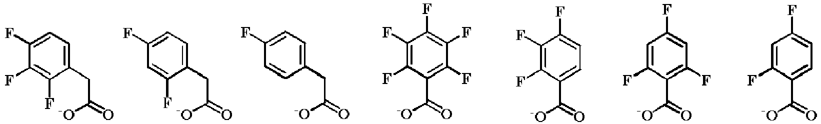

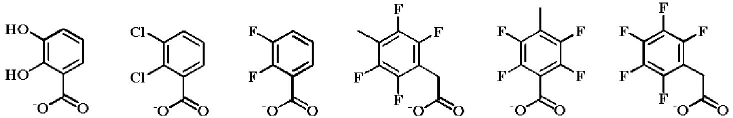

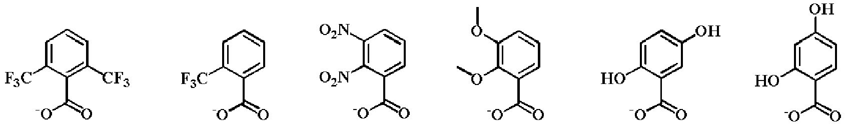

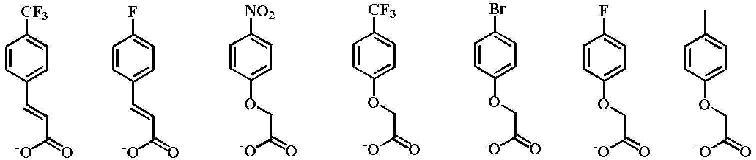

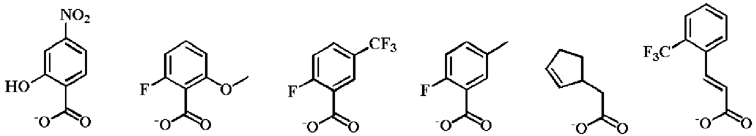

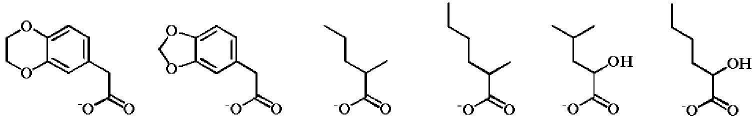

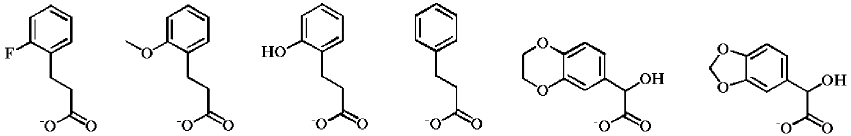

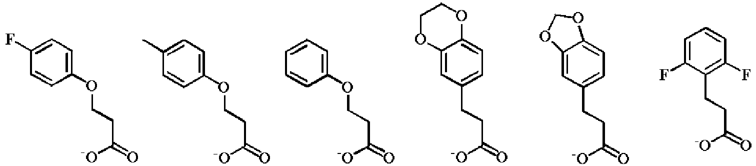

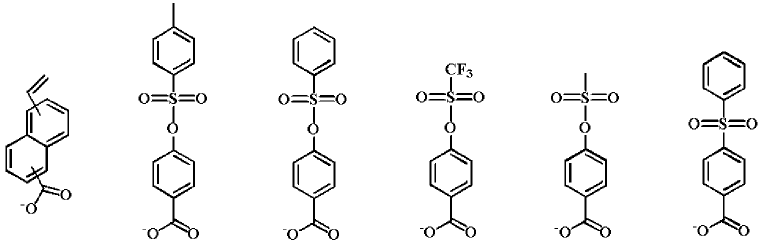

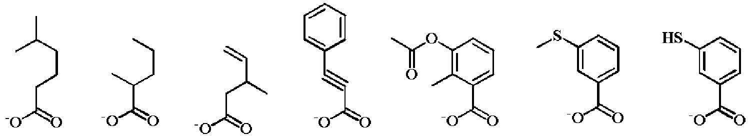

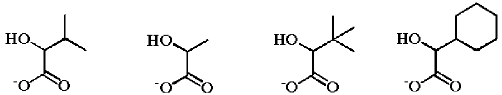

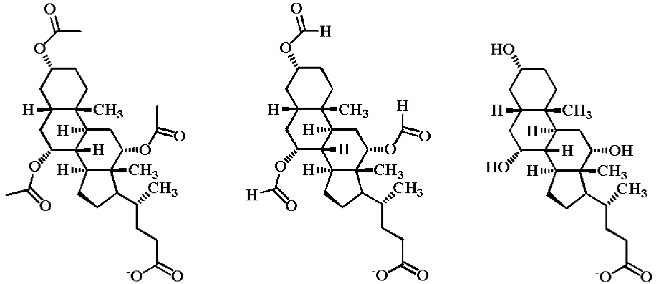

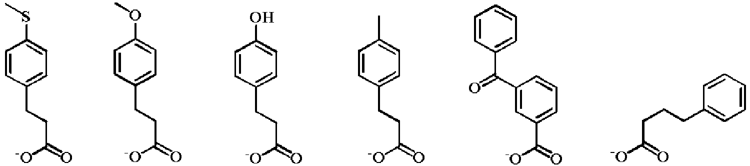

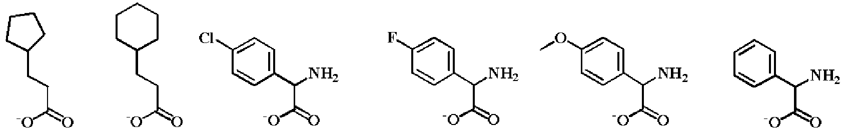

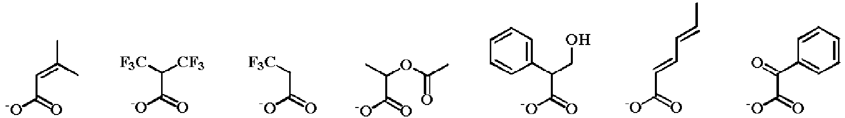

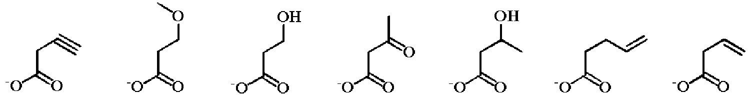

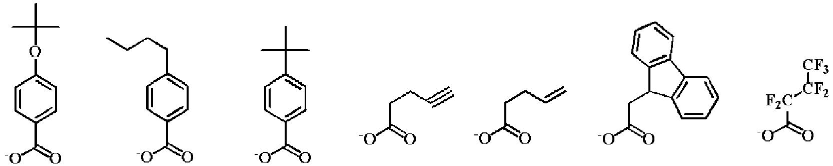

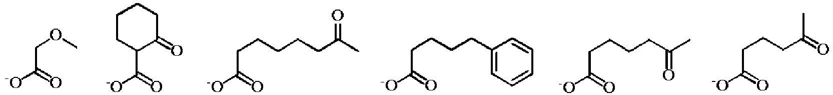

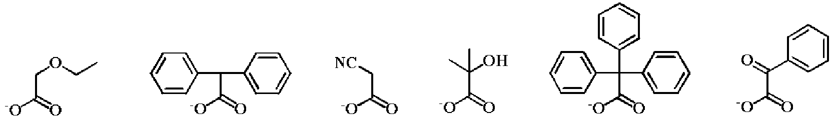

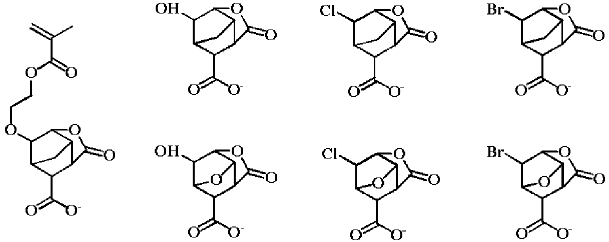

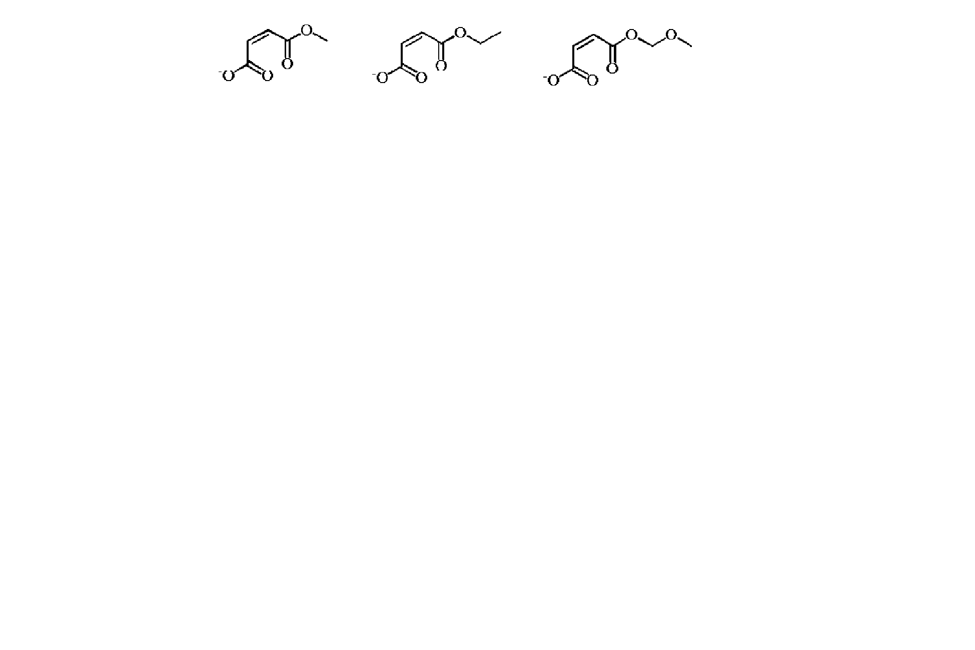

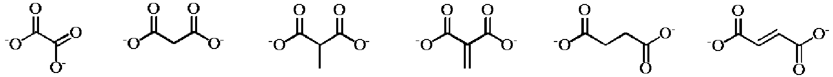

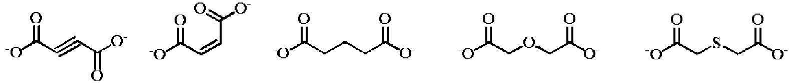

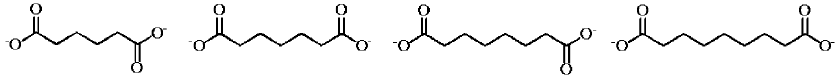

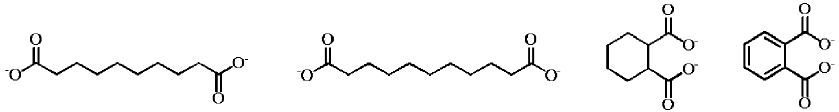

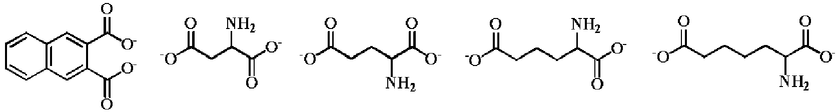

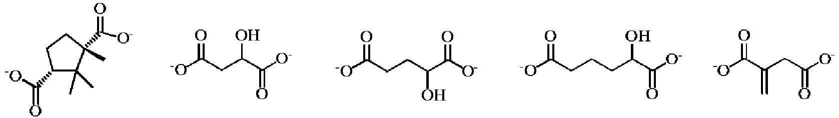

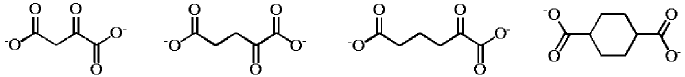

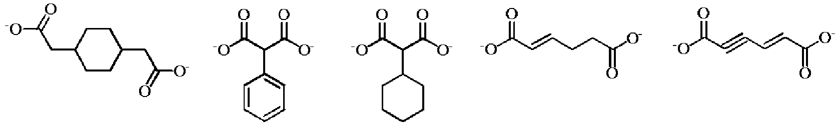

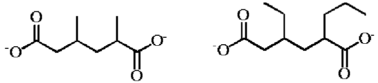

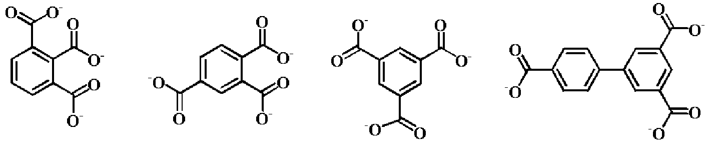

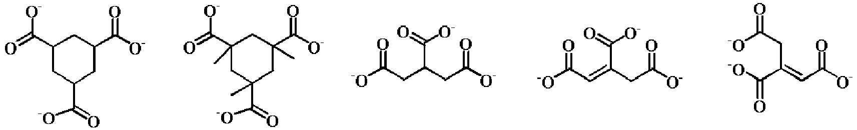

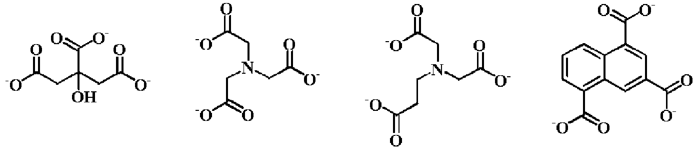

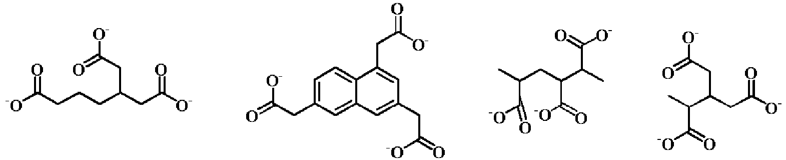

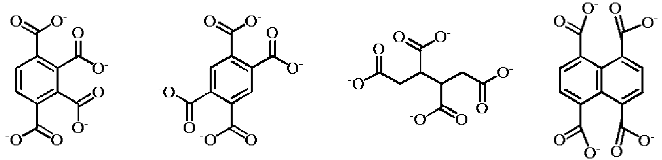

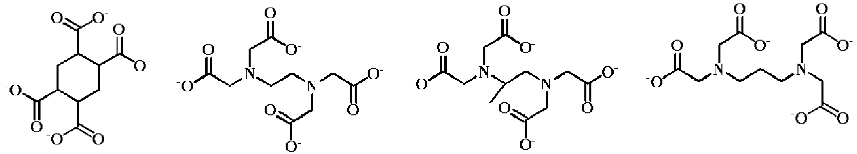

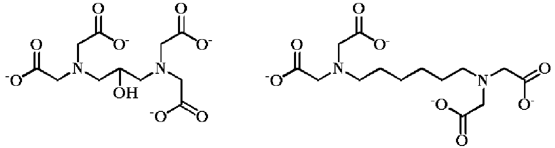

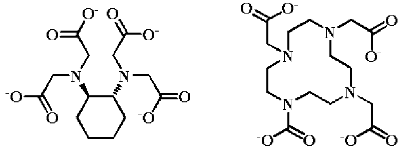

For the carboxylic acid ions for forming the carboxylic acid salt as described above, the carboxylic acid preferably has more carbon atoms as it is more easily dissolved in an organic solvent. Furthermore, if the carboxylic acid does not have too many carbon atoms, a shrinking amount is reduced upon formation of a resist film, and an amount of an outgas composition is also reduced. From the above-described viewpoints, the carboxylic acid ion is more preferably a linear or branched alkyl group having 3 to 10 carbon atoms.

Preferred examples of the β-diketone complex are illustrated below.

| | |
|---|---|
| Ti⁴⁺ (R¹COCH₂COR²)⁻₄ | |
| Cr²⁺ (R¹COCH₂COR²)⁻₂ | Cr³⁺ (R¹COCH₂COR²)⁻₃ |
| Mn²⁺ (R¹COCH₂COR²)⁻₂ | Mn³⁺ (R¹COCH₂COR²)⁻₃ |
| Fe²⁺ (R¹COCH₂COR²)⁻₂ | Fe³⁺ (R¹COCH₂COR²)⁻₃ |
| Co²⁺ (R¹COCH₂COR²)⁻₂ | |
| Ni²⁺ (R¹OCH₂COR²)⁻₂ | |
| Cu⁺ (R¹COCH₂COR²)⁻ | Cu²⁺ (R¹COCH₂COR²)⁻₂ |
| Zn⁺ (R¹COCH₂COR²)⁻ | Zn²⁺ (R¹COCH₂COR²)⁻₂ |
| Zr⁴⁺ (R¹COCH₂COR²)⁻₄ | |
| Mo⁴⁺ (R¹COCH₂COR²)⁻₄ | |
| In³⁺ (R¹COCH₂COR²)⁻₃ | |
| Sn²⁺ (R¹COCH₂COR²)⁻₂ | Sn⁴⁺ (R¹COCH₂COR²)⁻₄ |
| Hf⁴⁺ (R¹COCH₂COR²)⁻₄ | |
| Bi³⁺ (R¹COCH₂COR²)⁻₃ | |

(In the formulae, R¹ and R² may be identical to or different from each other, and represent linear, branched, or cyclic alkyl group having 1 to 20 carbon atoms, alkenyl group having 2 to 20 carbon atoms, alkynyl group having 2 to 20 carbon atoms, or aryl group having 6 to 20 carbon atoms, each of these optionally having a hydroxy group, alkoxy group, ether group, ester group, amino group, amide group, sulfonic acid ester group, halogen atom, cyano group, nitro group, carbonate group, carbamate group, thiol group, sulfide group, thioketone group, or heteroaromatic ring.)

The β-diketones in the above general formulae are substituted or unsubstituted acetylacetone, and specific examples thereof are illustrated below.

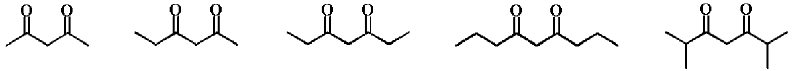

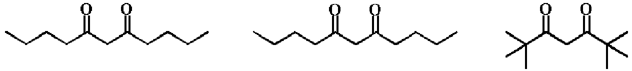

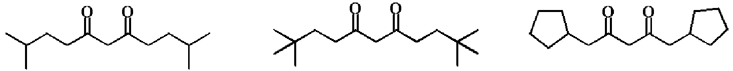

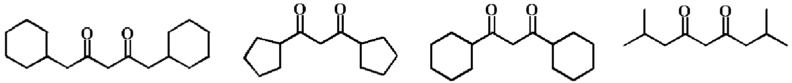

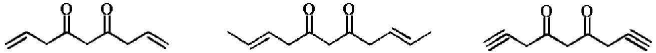

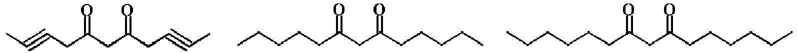

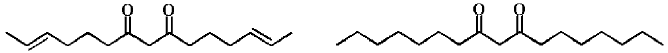

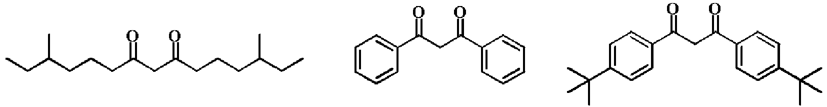

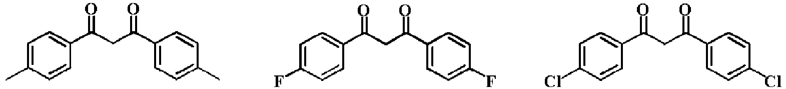

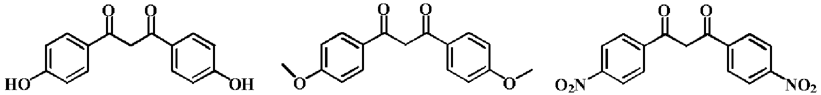

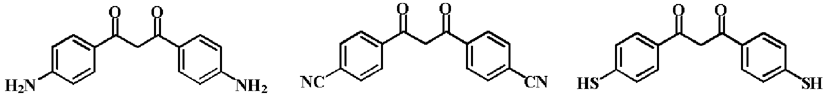

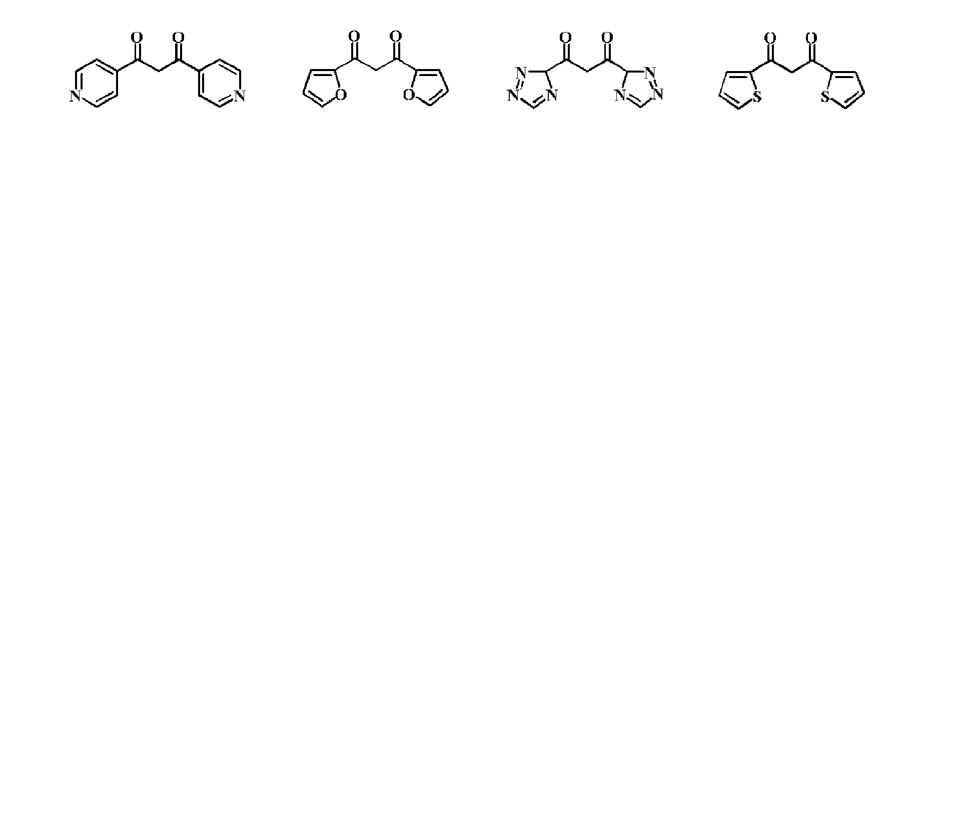

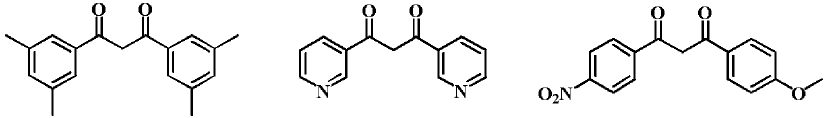

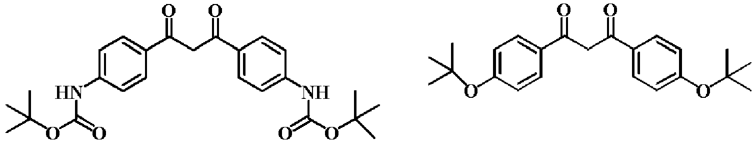

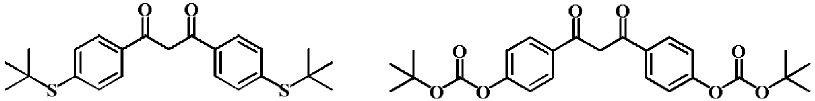

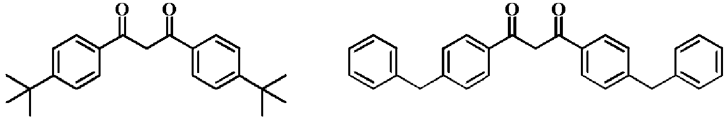

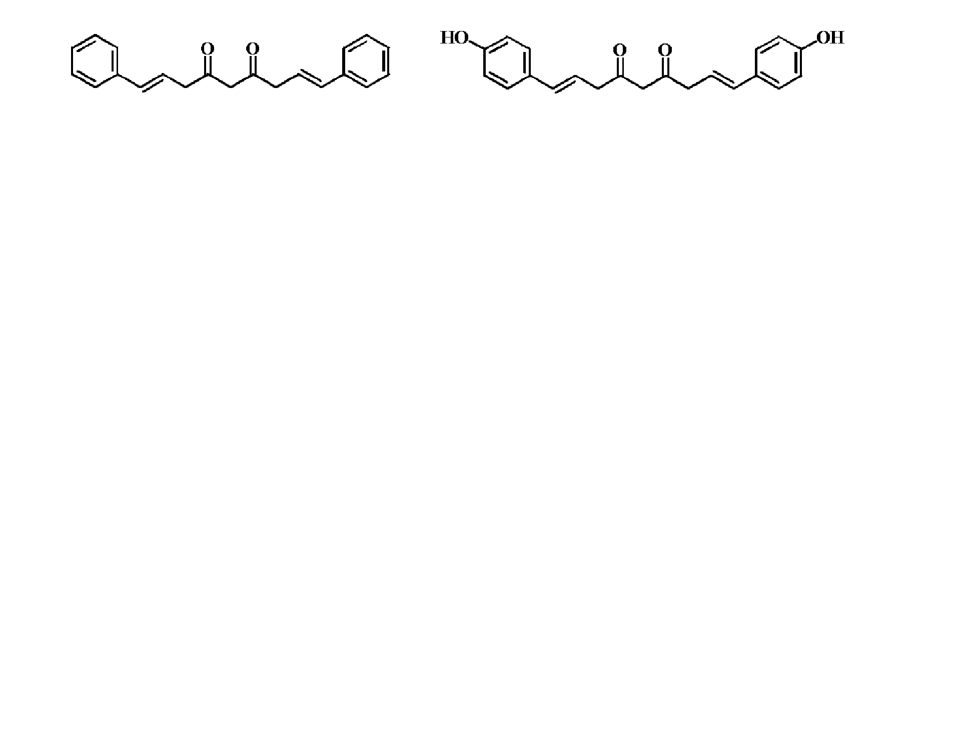

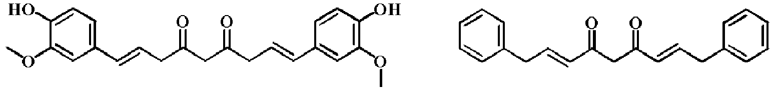

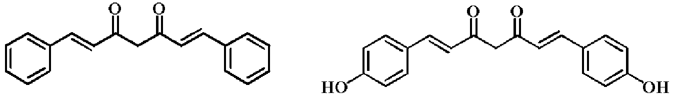

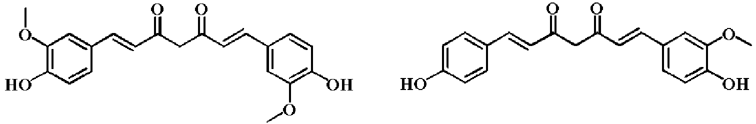

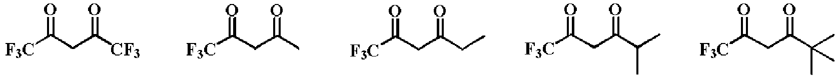

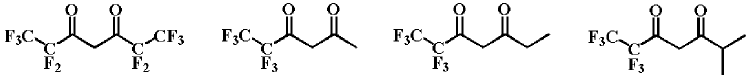

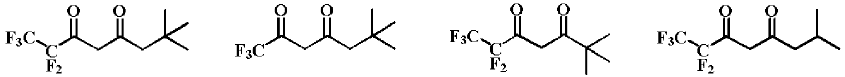

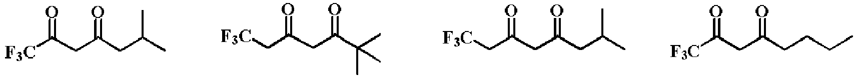

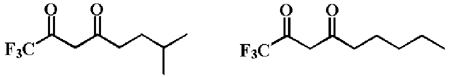

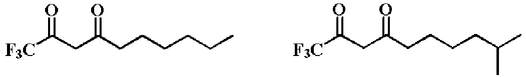

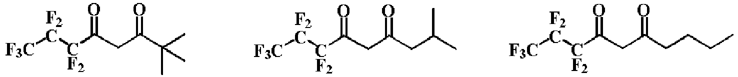

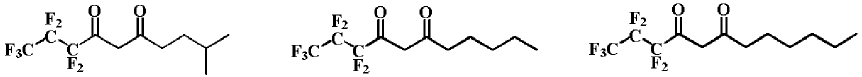

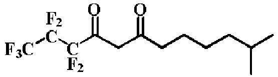

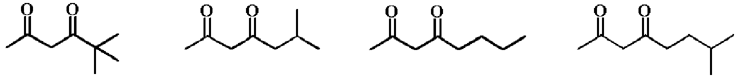

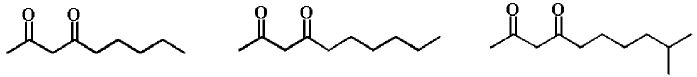

In a β-diketone, R¹ and R² are generally identical to each other. However, R¹ and R² may be different from each other as described in JP 2004-175755 A. The most common is acetylacetone in which both of R¹ and R² represent a methyl group, though it has disadvantage of poor solubility in an organic solvent. R¹ and R² preferably have a total of 3 or more carbon atoms, more preferably have a total of 4 or more carbon atoms.

It is preferable that a hydrogen atom of acetylacetone is substituted and the substituent has more carbon atoms as it is more easily dissolved in an organic solvent. The more carbon atoms the substituent has, the more improved the uniformity of film thickness is when the composition for forming an adhesive film is spin-coated. Furthermore, if the carboxylic acid does not have too many carbon atoms, a shrinking amount is reduced upon formation of an adhesive film, and an amount of an outgas composition is also reduced.

Acetylacetone undergoes enolization to form a complex with a metal as shown below.

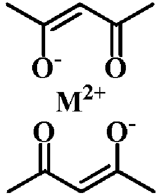

From the viewpoints of solubility in a solvent and availability of raw materials, the metal source (B) used in the composition for forming an adhesive film of the present invention is preferably a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms. Specifically, the metal source (B) more preferably has a structure represented by the following formula (B-1). 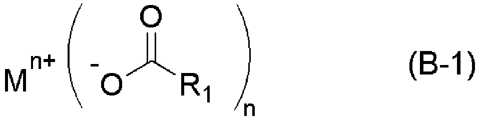 (In the formula, M is selected from any of Ti, Cr, Mn, Fe, Co, Ni, Cu, Zn, Zr, Mo, In, Sn, Hf, and Bi; R¹ represents a monovalent organic group having 1 to 30 carbon atoms: and "n" represents an integer of 1 to 4.)

From the viewpoints of solubility in an organic solvent, an amount of an outgas composition during baking, and productivity, R¹ in the above formula (B-1) more preferably represents a saturated or unsaturated hydrocarbon group having 1 to 10 carbon atoms, further preferably represents a branched alkyl group having 3 to 10 carbon atoms.

From the viewpoint of enhancement of exposure sensitivity of the resist upper layer film in EUV lithography, M in the above formula (B-1) more preferably represents Ti, Hf, Sn, or Bi, and further preferably represents Sn.

The amount of the metal source (B) in the composition for forming an adhesive film is preferably 1 to 200 parts by mass, more preferably 5 to 100 parts by mass, and further preferably 10 to 50 parts by mass relative to 100 parts by mass of the organic polymer (A). When the amount of the metal source (B) is 1 part by mass or more, sufficient contribution to enhancement of the exposure sensitivity of the resist upper layer film can be achieved in EUV lithography. When the amount of the metal source (B) is 200 parts by mass or less, sufficient adhesiveness to the resist upper layer film pattern can be obtained, thereby controlling pattern collapse of the resist upper layer film. These can be adjusted as appropriate depending on the required properties when used in the composition for forming an adhesive film.

### <(C) Organic Solvent>

The organic solvent (C) usable in the composition for forming an adhesive film of the present invention is not particularly limited, as long as the organic polymer (A) and the metal source (B) as described above, as well as (D) a thermal acid generator, (E) a photoacid generator, (F) a crosslinking agent, (G) a surfactant, and other additives as described later (if contained) can be dissolved or dispersed therein.

Specifically, the organic solvent (C) is monoalkyl ether such as ethylene glycol, diethylene glycol, and triethylene glycol, or monoalkyl ether such as propylene glycol and dipropylene glycol. Specifically, preferably used is propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, 2-heptanone, cyclopentanone, cyclohexanone, γ-butyrolactone, or a mixture containing one or more thereof.

The blending amount of the organic solvent is preferably in the range of 200 to 10,000 parts, more preferably 250 to 5,000 parts relative to 100 parts by mass of the metal source (B).

### <(C-1) High-Boiling-Point Solvent>

In the composition for forming an adhesive film of the present invention, the organic solvent (C) may contain (C-1) a high-boiling-point solvent.

The high-boiling-point solvent (C-1) can be one or more kinds of organic solvents having a boiling point of 180 degrees (°C) or higher.

For example, as the organic solvent (C), a mixture of one or more kinds of organic solvents having a boiling point of less than 180°C and one or more kinds of organic solvents having a boiling point of 180°C or higher (the high-boiling-point solvent (C-1)) may be used.

The high-boiling-point solvent (C-1) is not particularly limited to hydrocarbons, alcohols, ketones, esters, ethers, or chlorinated solvents as long as the respective components of the composition for forming an adhesive film of the present invention can be dissolved or dispersed therein. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, triethanolamine, and the like. These may be used alone or in mixture.

The high-boiling-point solvent (C-1) may appropriately be selected from, for example, those described above depending on the temperature for heat treatment of the composition for forming an adhesive film of the present invention, etc. The high-boiling-point solvent preferably has a boiling point of 180°C to 300°C, further preferably has a boiling point of 200°C to 300°C. Since there is no risk of too quick volatilization during baking (heat treatment) at such boiling point, it is possible to prevent defects caused by dryness during film formation. Furthermore, since the solvent having such boiling point evaporates and does not remain in the film after baking, there is no risk of a bad influence on physical properties of the film such as etching resistance.

Furthermore, the blending amount of the high-boiling-point solvent (C-1) (if used) is preferably 1 to 30 parts by mass relative to 100 parts by mass of the organic solvent having a boiling point of less than 180°C. Such blending amount is preferred because it enables to impart sufficient thermal flowability during baking and the solvent does not remain in the film, causing no deterioration in physical properties of the film such as etching resistance.

### <Other Components>

The above composition for forming an adhesive film may contain at least one or more of (D) a thermal acid generator, (E) a photoacid generator, (F) a crosslinking agent, and (G) a surfactant as necessary.

Hereinafter, components that can be contained in the composition for forming an adhesive film of the present invention other than the organic polymer (A), the metal source (B), and the organic solvent (C) as described above will be described.

### (D) Thermal Acid Generator

In the composition for forming an adhesive film of the present invention, (D) a thermal acid generator is preferably added in order to facilitate a thermal crosslinking reaction.

Examples of the thermal acid generator (D) usable in the composition for forming an adhesive film of the present invention include the following general formula (7), etc. 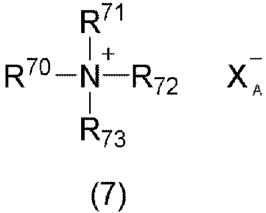 (In the formula, X_{A}⁻ represents a non-nucleophilic counter ion; each of R⁷⁰, R⁷¹, R⁷², and R⁷³ represents a hydrogen atom or a linear, branched, or cyclic alkyl group, alkenyl group, oxoalkyl group, or oxoalkenyl group each having 1 to 12 carbon atoms, an aryl group having 6 to 20 carbon atoms, or an aralkyl or aryloxoalkyl group having 7 to 12 carbon atoms, where some or all of hydrogen atoms of these groups may be substituted with an alkoxy group or the like; additionally, R⁷⁰ and R⁷¹, or R⁷⁰, R⁷¹, and R⁷² may form a ring, and when forming a ring, R⁷⁰ and R⁷¹, or R⁷⁰, R⁷¹, and R⁷² represent an alkylene group having 3 to 10 carbon atoms or a heteroaromatic ring containing the nitrogen atom in the formula in its ring.)

The above R⁷⁰, R⁷¹, R⁷², and R⁷³ may be the same or different from each other. Specific examples of the alkyl group include methyl group, ethyl group, propyl group, isopropyl group, n-butyl group, sec-butyl group, tert-butyl group, pentyl group, hexyl group, heptyl group, octyl group, cyclopentyl group, cyclohexyl group, cycloheptyl group, cyclopropylmethyl group, 4-methylcyclohexyl group, cyclohexylmethyl group, norbornyl group, adamantyl group, and the like.

Examples of the alkenyl group include vinyl group, allyl group, propenyl group, butenyl group, hexenyl group, cyclohexenyl group, and the like.

Examples of the oxoalkyl group include 2-oxocyclopentyl group, 2-oxocyclohexyl group, 2-oxopropyl group, 2-cyclopentyl-2-oxoethyl group, 2-cyclohexyl-2-oxoethyl group, 2-(4-methylcyclohexyl)-2-oxoethyl group, and the like.

Examples of the oxoalkenyl group include 2-oxo-4-cyclohexenyl group, 2-oxo-4-propenyl group, and the like.

Examples of the aryl group include: phenyl group, naphthyl group, and the like; alkoxyphenyl groups such as p-methoxyphenyl group, m-methoxyphenyl group, o-methoxyphenyl group, ethoxyphenyl group, p-tert-butoxyphenyl group, and m-tert-butoxyphenyl group; alkylphenyl groups such as 2-methylphenyl group, 3-methylphenyl group, 4-methylphenyl group, ethylphenyl group, 4-tert-butylphenyl group, 4-butylphenyl group, and dimethylphenyl group; alkylnaphthyl groups such as methylnaphthyl group and ethylnaphthyl group; alkoxynaphthyl groups such as methoxynaphthyl group and ethoxynaphthyl group; dialkylnaphthyl groups such as dimethylnaphthyl group and diethylnaphthyl group; and dialkoxynaphthyl groups such as dimethoxynaphthyl group and diethoxynaphthyl group.

Examples of the aralkyl group include benzyl group, phenylethyl group, phenethyl group, and the like.

Examples of the aryloxoalkyl group include 2-aryl-2-oxoethyl groups such as 2-phenyl-2-oxoethyl group, 2-(1-naphthyl)-2-oxoethyl group, and 2-(2-naphthyl)-2-oxoethyl group.

Furthermore, when R⁷⁰ and R⁷¹, or R⁷⁰, R⁷¹, and R⁷² form a heteroaromatic ring containing the nitrogen atom in the formula in its ring, examples thereof include imidazole derivatives (e.g., imidazole, 4-methylimidazole, 4-methyl-2-phenylimidazole, etc.), pyrazole derivatives, furazan derivatives, pyrroline derivatives (e.g., pyrroline, 2-methyl-1-pyrroline, etc.), pyrrolidine derivatives (e.g., pyrrolidine, N-methylpyrrolidine, pyrrolidinone, N-methylpyrrolidone, etc.), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline, 3-quinolinecarbonitrile, etc.), isoquinoline derivatives, cinnoline derivatives, quinazoline derivatives, quinoxaline derivatives, phthalazine derivatives, purine derivatives, pteridin derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivative, uridine derivatives, and the like.

Examples of the above non-nucleophilic counter ion X_{A}⁻ include: halide ions such as chloride ions and bromide ions; fluoroalkyl sulfonates such as triflate, 1,1,1-trifluoroethanesulfonate, and nonafluorobutanesulfonate; aryl sulfonates such as tosylate, benzenesulfonate, 4-fluorobenzenesulfonate, and 1,2,3,4,5-pentafluorobenzenesulfonate; alkyl sulfonates such as mesylate and butanesulfonate; imidic acids such as bis(trifluoromethylsulfonyl)imide, bis(perfluoroethylsulfonyl)imide, and bis(perfluorobutylsulfonyl)imide; methide acids such as tris(trifluoromethylsulfonyl)methide and tris(perfluoroethylsulfonyl)methide; and further, sulfonate fluorinated at α-position represented by the following general formula (8) and sulfonate fluorinated at α- and β-positions represented by the following general formula (9).

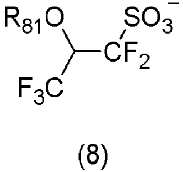

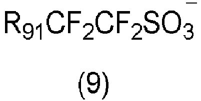

In the above general formula (8), R₈₁ represents a hydrogen atom, a linear, branched, or cyclic alkyl group having 1 to 23 carbon atoms, an acyl group, an alkenyl group having 2 to 20 carbon atoms, an aryl group having 6 to 20 carbon atoms, or an aryloxy group. In the above general formula (9), R₉₁ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the above thermal acid generator are illustrated below, but not limited thereto.

(CH₃CH₂)₃N⁺H (CH₃CH₂)₃N⁺H (CH₃CH₂)₃N⁺H (CH₃CH₂)₃N⁺H (CH₃CH₂)₃N⁺H C₄F₉SO₃⁻ 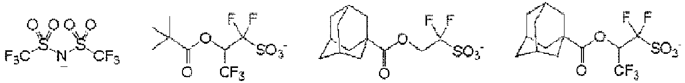 (CH₃CH₂)₃N⁺H (CH₃CH₂)₃N⁺H (CH₃CH₂)₃N⁺H

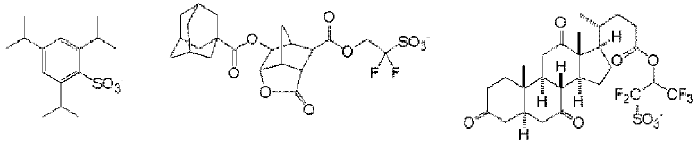

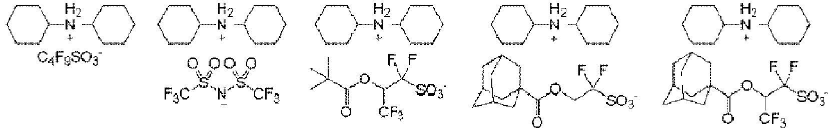

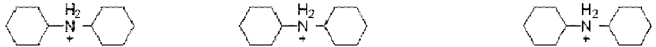

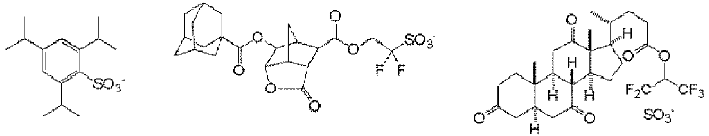

The thermal acid generator (D) contained in the composition for forming an adhesive film of the present invention can be used alone or in combination of two or more kinds thereof. The amount of the thermal acid generator to be added is preferably 0.05 to 30 parts by mass, more preferably 0.1 to 10 parts by mass relative to 100 parts by mass of the above organic polymer (A). The amount of 0.05 parts by mass or more results in sufficient amount of acid generation and a sufficient crosslinking reaction, whereas the amount of 30 parts by mass or less results in a low risk of a mixing phenomenon due to acid migration to the upper layer resist.

### (E) Photoacid Generator

To the composition for forming an adhesive film of the present invention, (E) a photoacid generator can be added in order to appropriately adjust the pattern profile of the resist upper layer film, exposure sensitivity, etc. The photoacid generator can be used alone or in combination of two or more kinds thereof. For example, those described in paragraphs [0160] to [0179] of JP 2009-126940 A can be used as the photoacid generator. The amount of the photoacid generator to be added is preferably 0.05 to 30 parts by mass, more preferably 0.1 to 10 parts by mass relative to 100 parts by mass of the above organic polymer (A). The addition amount of the photoacid generator within the above range leads to favorable resolution and no risk of a problem of foreign substances occurring after resist development or during debonding.

### (F) Crosslinking Agent

Additionally, to the composition for forming an adhesive film of the present invention, (F) a crosslinking agent can also be added in order to enhance a curing property and further prevent intermixing with the resist upper layer film.

The crosslinking agent is not particularly limited, and known crosslinking agents of various types can widely be used. One example thereof includes melamine crosslinking agents, glycoluril crosslinking agents, benzoguanamine crosslinking agents, urea crosslinking agents, β-hydroxyalkylamide crosslinking agents, isocyanurate crosslinking agents, aziridine crosslinking agents, oxazoline crosslinking agents, and epoxy crosslinking agents. The above crosslinking agent (F) can be used alone or in combination of two or more kinds thereof. The addition amount of the crosslinking agent (F) (if added) is preferably 5 to 100 parts by mass, more preferably 10 to 50 parts by mass relative to 100 parts by mass of the above organic polymer (A). When the addition amount is 5 parts by mass or more, the sufficient curing property can be exhibited, thereby preventing intermixing with the resist upper layer film. On the other hand, when the addition amount is 50 parts by mass or less, there is no risk of deteriorated dry etching resistance due to the decreased proportion of the metal source (B) in the composition.

Specific examples of the melamine crosslinking agents include hexamethoxymethylated melamine, hexabutoxymethylated melamine, alkoxy- and/or hydroxy-substituted derivatives thereof, and partial self-condensates thereof.

Specific examples of the glycoluril crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea crosslinking agents include dimethoxymethylated dimethoxyethyleneurea, alkoxy- and/or hydroxy-substituted derivatives thereof, and partial self-condensates thereof.

Specific examples of the β-hydroxyalkylamide crosslinking agents include N,N,N',N'-tetra(2-hydroxyethyl)adipic acid amide.

Specific examples of the isocyanurate crosslinking agents include triglycidyl isocyanurate and triallyl isocyanurate.

Specific examples of the aziridine crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline crosslinking agents include 2,2'-isopropylidenebis(4-benzyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tertbutyl-2-oxazoline, 2,2'-bis(2-oxazoline), 1,3-phenylenebis(2-oxazoline), 1,4-phenylenebis(2-oxazoline), and 2-isopropenyloxazoline copolymer.

Specific examples of the epoxy crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Examples of the epoxy crosslinking agents and oxetane crosslinking agents are shown below, but not limited thereto.

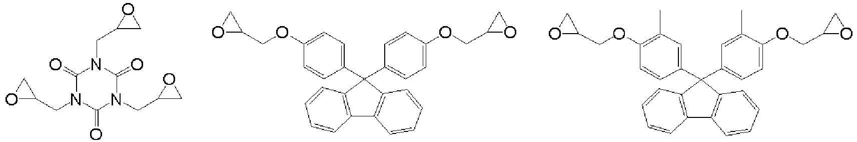

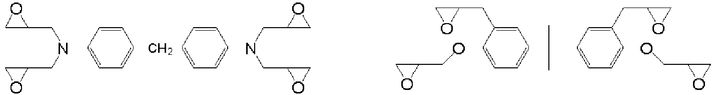

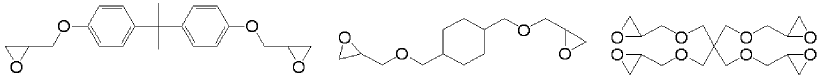

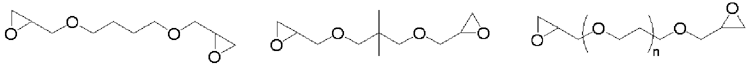

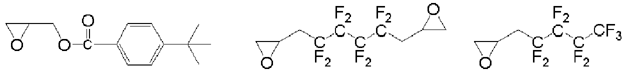

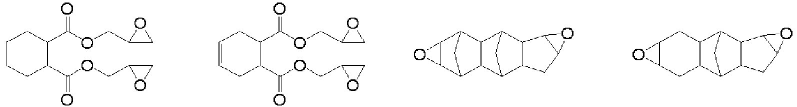

It is possible to purchase the above compounds, but it is also possible to obtain the epoxy crosslinking agents and the oxetane crosslinking agents by reacting a hydroxyl group with epibromohydrin or 3-bromomethyloxetane, etc. as in the following formula. In the following formula, R₅ represents a substituted or unsubstituted saturated monovalent organic group having 1 to 20 carbon atoms or unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. Additionally, it is possible that hydroxyl groups are not entirely reacted and some are left unreacted. In this case, the total number of epoxy groups and oxetane groups is preferably greater than the number of hydroxyl groups, and more preferably, the total number of epoxy groups and oxetane groups is greater than two times the number of hydroxyl groups.

Furthermore, these compounds are contained in an amount of preferably 5 to 100 parts by mass, more preferably 10 to 50 parts by mass relative to 100 parts by mass of the metal source (B).

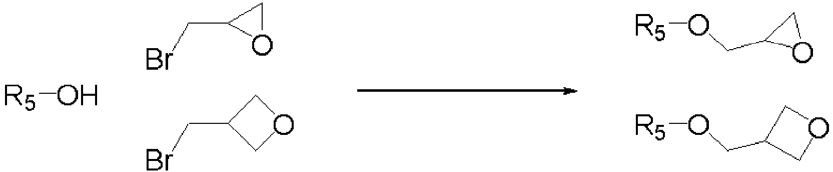

Specific examples of the compound having the hydroxyl group usable for the above reaction are shown below, but not limited thereto.

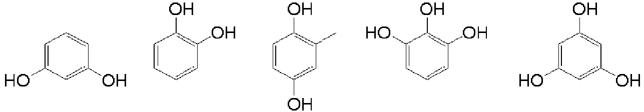

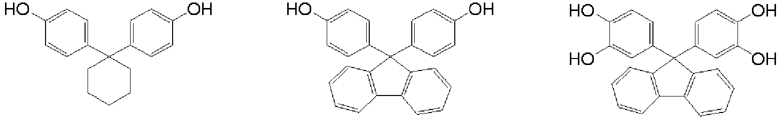

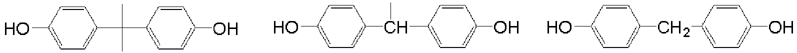

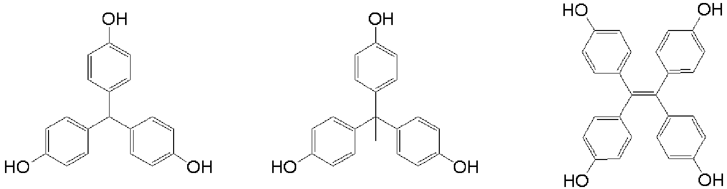

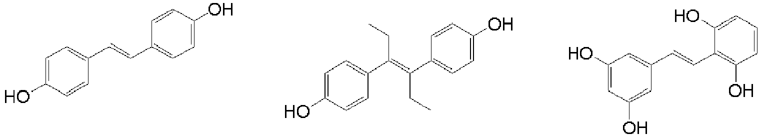

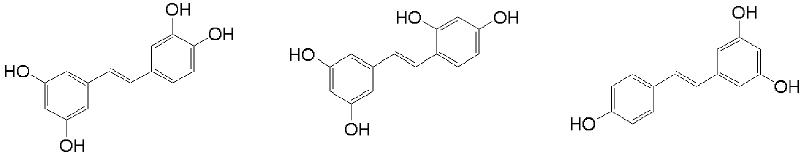

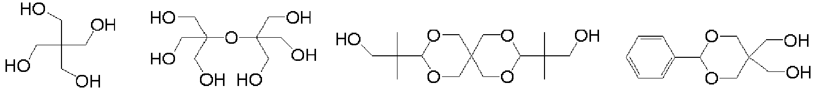

### (G) Surfactant

To the composition for forming an adhesive film of the present invention, (G) a surfactant can be added in order to enhance application performance by spin coating. The surfactant can be used alone or in combination of two or more kinds thereof. For example, those described in paragraphs [0142] to [0147] of JP 2009-269953 A can be used as the surfactant. The addition amount of the surfactant (if added) is preferably 0.001 to 20 parts by mass, more preferably 0.01 to 10 parts by mass relative to 100 parts by mass of the above organic polymer (A). The amount within this range can ensure the enhanced application performance to form a thin and uniform adhesive film.

### Plasticizer

Additionally, a plasticizer can be added to the composition for forming an adhesive film of the present invention. The plasticizer is not particularly limited, and known plasticizers of various types can widely be used. One example thereof includes: low-molecular-weight compounds such as phthalate esters, adipate esters, phosphate esters, trimellitate esters, and citrate esters; and polymers such as polyether polymers, polyester polymers, and polyacetal polymers described in JP 2013-253227 A. The amount of the plasticizer to be added is preferably 1 to 500 parts by mass relative to 100 parts by mass of the above organic polymer (A). The addition amount within this range enables excellent filling and levelling of a pattern.

### <Method for Forming Adhesive Film>

In the present invention, the above-described composition for forming an adhesive film can be used to form an adhesive film that is formed between a silicon-containing middle layer film and a resist upper layer film of a multilayer resist film used for lithography, for example.

In a method for forming an adhesive film using the composition for forming an adhesive film of the present invention, the above-described composition for forming an adhesive film is coated on a substrate to be processed by a spin coat method or the like. After the spin coating, baking (heat treatment) is performed to evaporate the solvent and facilitate a crosslinking reaction to prevent mixing with the resist upper layer film. The baking is preferably performed at 100°C or higher and 450°C or lower for 10 to 600 seconds, more preferably performed at 200°C or higher and 300°C or lower for 10 to 300 seconds. Considering effects on device damage and deformation of a wafer, the upper limit of the heating temperature in a wafer process of lithography is preferably 450°C or lower and more preferably 300°C or lower.

Furthermore, in the method for forming an adhesive film using the composition for forming an adhesive film of the present invention, an adhesive film can also be formed by coating the composition for forming an adhesive film of the present invention on a substrate to be processed by a spin coat method or the like in the same manner as described above, and baking and curing the composition for forming an adhesive film in an atmosphere with an oxygen concentration of 0.1% by volume or more and 21% by volume or less.

By baking the composition for forming an adhesive film of the present invention in such oxygen atmosphere, it is possible to obtain a sufficiently cured film. While the atmosphere during the baking may be air, filling an inert gas such as N₂, Ar, or He to reduce the amount of oxygen is preferable to prevent oxidation of the adhesive film. To prevent oxidation, it is necessary to control the oxygen concentration, which is preferably 1000 ppm or less and more preferably 100 ppm or less (volume basis). It is preferable to prevent oxidation of the adhesive film during the baking so as not to cause increased absorption or reduced etching resistance.

Alternatively, the above-described composition for forming an adhesive film can be used to form a resist middle layer film as a middle layer film of a multilayer resist film used for lithography, for example.

### <Patterning Process>

As a patterning process with a four-layer resist process using the composition for forming an adhesive film of the present invention, the present invention also provides a patterning process for forming a pattern in a substrate to be processed, including steps of:
(I-1) forming a resist underlayer film on the substrate to be processed;
(I-2) forming a silicon-containing resist middle layer film on the resist underlayer film;
(I-3) applying the composition for forming an adhesive film of the present invention on the silicon-containing resist middle layer film and thereafter performing heat treatment to form an adhesive film;
(I-4) forming a resist upper layer film on the adhesive film using a photoresist material;
(I-5) forming a pattern in the resist upper layer film by developing the resist upper layer film using a developer after pattern exposure;
(I-6) transferring the pattern to the adhesive film by dry etching while using the resist upper layer film having the formed pattern as a mask;
(I-7) transferring the pattern to the silicon-containing resist middle layer film by dry etching while using the adhesive film having the formed pattern as a mask;
(I-8) transferring the pattern to the resist underlayer film by dry etching while using the silicon-containing resist middle layer film having the transferred pattern as a mask; and
(I-9) transferring the pattern to the substrate to be processed by dry etching while using the resist underlayer film having the transferred pattern as a mask.

As a patterning process with a four-layer resist process using the composition for forming an adhesive film of the present invention, the present invention also provides a patterning process for forming a pattern in a substrate to be processed, including steps of:
(II-1) forming a resist underlayer film on the substrate to be processed;
(II-2) forming an inorganic hard mask middle layer film selected from a silicon oxide film, a silicon nitride film, and a silicon oxynitride film on the resist underlayer film;
(II-3) applying the composition for forming an adhesive film of the present invention on the inorganic hard mask middle layer film and thereafter performing heat treatment to form an adhesive film;
(II-4) forming a resist upper layer film on the adhesive film using a photoresist material;
(II-5) forming a pattern in the resist upper layer film by developing the resist upper layer film using a developer after pattern exposure;
(II-6) transferring the pattern to the adhesive film by dry etching while using the resist upper layer film having the formed pattern as a mask;
(II-7) transferring the pattern to the inorganic hard mask middle layer film by dry etching while using the adhesive film having the formed pattern as a mask; (II-8) transferring the pattern to the resist underlayer film by dry etching while using the inorganic hard mask middle layer film having the transferred pattern as a mask; and
(II-9) transferring the pattern to the substrate to be processed by dry etching while using the resist underlayer film having the transferred pattern as a mask.

An example of the inventive patterning process with a four-layer resist method will be described herein with reference to FIGs. 1(A) to 1(F). In the case of the four-layer resist method, as illustrated in FIG. 1(A), an organic resist underlayer film 3 is formed on a layer to be processed 2 formed on a substrate to be processed 1 using an organic resist underlayer film composition, a silicon-containing resist middle layer film 4 is then formed, an adhesive film 5 is formed thereon using the composition for forming an adhesive film of the present invention, and further a resist upper layer film 6 is formed thereon. Then, an exposed portion 7 of the resist upper layer film 6 is exposed to light, followed by PEB (post exposure bake), as illustrated in FIG. 1(B). Next, development is performed to form a resist upper layer film pattern 6a as illustrated in FIG. 1(C). Next, as illustrated in FIG. 1(D), the adhesive film 5 and the silicon-containing resist middle layer film 4 are processed by dry etching with a fluorine gas while using the resist upper layer film pattern 6a as a mask, thereby forming an adhesive film pattern 5a and a silicon-containing resist middle layer film pattern 4a. Next, as illustrated in FIG. 1(E), the resist upper layer film pattern 6a and the adhesive film pattern 5a are removed and thereafter the organic resist underlayer film 3 is subjected to oxygen plasma etching by using the silicon-containing resist middle layer film pattern 4a as a mask, thereby forming an organic resist underlayer film pattern 3a. Further, as illustrated in FIG. 1(F), the silicon-containing resist middle layer film pattern 4a is removed and thereafter the layer to be processed 2 is etched by using the organic resist underlayer film pattern 3a as a mask, thereby forming a pattern 2a.

In the case of forming the inorganic hard mask middle layer film, the silicon-containing resist middle layer film 4 may be changed to the inorganic hard mask middle layer film.

The resist upper layer film in the above four-layer resist process has etching resistance to a fluorine gas or a chlorine gas. Accordingly, in the above four-layer resist process, the dry etching of the adhesive film while using the resist upper layer film as a mask is preferably performed by using an etching gas mainly composed of a fluorine gas or a chlorine gas. The dry etching of the silicon-containing resist middle layer film or the inorganic hard mask middle layer film while using the resist upper layer film and the adhesive film as a mask is preferably performed by using an etching gas mainly composed of a fluorine gas. Since the silicon-containing resist middle layer film and the inorganic hard mask middle layer film have etching resistance to an oxygen gas, the dry etching of the organic resist underlayer film while using the silicon-containing resist middle layer film or the inorganic hard mask middle layer film as a mask is preferably performed by using an etching gas mainly composed of an oxygen gas. Since the organic resist underlayer film has etching resistance to a fluorine gas, the dry etching of the substrate to be processed while using the organic resist underlayer film as a mask is preferably performed by using an etching gas mainly composed of a fluorine gas.

The adhesive film of the present invention is preferably a thin film in order to reduce the dry etching process time. The thickness of the adhesive film is preferably 20 nm or less, more preferably 15 nm or less, further preferably 10 nm or less, and particularly preferably 5 nm or less.

In the above patterning process, the resist upper layer film may be either a positive or negative type, and the same one as a typically used photoresist composition can be used therefor. In a case of forming the resist upper layer film with the above photoresist composition, a spin coat method is preferred.

When the resist upper layer film is formed by the spin coat method using the photoresist composition, prebaking is performed after resist application, preferably at 60 to 180°C for 10 to 300 seconds. Thereafter, exposure is performed according to a usual manner, followed by post exposure bake (PEB) and development, thereby obtaining a resist pattern. Note that the thickness of the resist upper layer film is not particularly limited, but preferably 10 to 500 nm and particularly preferably 20 to 400 nm.

Note that exposure light includes high-energy ray having a wavelength of 300 nm or less; specifically, far ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) with 3 to 20 nm, electron beam (EB), ion beam, X-ray, and the like.

The pattern exposure is preferably performed using EUV light in the step (I-5) or (II-5).

The above patterning process for the resist upper layer film is preferably a patterning process using photolithography with a wavelength of 5 nm or more and 300 nm or less, direct drawing using an electron beam, nanoimprinting, or a combination thereof.

Additionally, the development method in the patterning process is preferably alkaline development or development using an organic solvent.

As the silicon-containing resist middle layer film in the above four-layer resist process, for example, a polysiloxane-based middle layer film is preferably used. By providing the silicon-containing resist middle layer film with an antireflection effect, it is possible to suppress reflection. When a material containing many aromatic groups and having high etch selectivity to the substrate is used as the organic film especially for exposure at 193 nm, the k-value and thus the substrate reflection increase; whereas when the silicon-containing resist middle layer film absorbs light to achieve the appropriate k-value, the reflection can be suppressed, thereby reducing the substrate reflection to 0.5% or less. Preferably used as the silicon-containing resist middle layer film having the antireflection effect is polysiloxane having a pendant anthracene for exposure at 248 nm or 157 nm, or a pendant phenyl group or a pendant light-absorbing group having a silicon-silicon bond for exposure at 193 nm, where the polysiloxane is crosslinked by acid or heat.

In the case of forming the inorganic hard mask middle layer film, it is possible to form a silicon oxide film, a silicon nitride film, and a silicon oxynitride film (SiON film) by CVD or ALD or other methods. Examples of the method for forming the silicon nitride film are described in JP 2002-334869 A and WO 2004/066377 A1. The film thickness of the inorganic hard mask is preferably 5 to 200 nm, more preferably 10 to 100 nm. Additionally, as the inorganic hard mask, a SiON film which is highly effective as the antireflective film is most preferably used. Since substrate temperature during forming the SiON film becomes 300 to 500°C, the resist underlayer film should withstand the temperature of 300 to 500°C. The resist underlayer film used for the present invention has high heat resistance and can withstand a high temperature of 300°C to 500°C, thereby allowing a combination of the inorganic hard mask middle layer film formed by a CVD or ALD method and the resist underlayer film formed by a spin coat method.

Examples of the organic resist underlayer film material usable for the above resist underlayer film include already known underlayer films for a three-layer resist method or a two-layer resist method using a silicon resist composition. The examples thereof include resins and compositions described in JP 2012-1687 A, JP 2012-77295 A, JP 2004-264710 A, JP 2005-043471 A, JP 2005-250434 A, JP 2007-293294 A, JP 2008-65303 A, JP 2004-205685 A, JP 2007-171895 A, JP 2009-14816 A, JP 2007-199653 A, JP 2008-274250 A, JP 2010-122656 A, JP 2012-214720 A, JP 2014-29435 A, WO 2012/077640 A1, WO 2010/147155 A1, WO 2012/176767 A1, JP 2005-128509 A, JP 2006-259249 A, JP 2006-259482 A, JP 2006-293298 A, JP 2007-316282 A, JP 2012-145897 A, JP 2017-119671 A, JP 2019-44022 A, etc.

The above resist underlayer film can be formed on the substrate to be processed by the spin coat method or the like as with the photoresist composition, using, for example, a composition solution containing the above organic resist underlayer film material. After forming the organic resist underlayer film by the spin coat method or the like, baking is preferably performed to evaporate the organic solvent. Preferably, the baking temperature is within a range of 100 to 600°C and the baking time is within a range of 10 to 300 seconds.

Instead of the above organic resist underlayer film material, it is also possible to apply an organic hard mask formed by a CVD or ALD method.

Note that the workpiece (substrate to be processed) is not particularly limited, and a substrate made of Si, α-Si, p-Si, SiO₂, SiN, SiON, W, TiN, Al, or the like, the substrate on which a layer to be processed is deposited, etc. are used. As the layer to be processed, various Low-k films such as those made of Si, SiO₂, SiON, SiN, p-Si, α-Si, W, W-Si, Al, Cu, Al-Si, or the like, and a stopper film thereof are used, which can be formed to have a thickness of typically 50 to 10,000 nm and particularly 100 to 5,000 nm. Note that in the case of depositing the layer to be processed, the substrate and the layer to be processed for use are made of different materials.

### EXAMPLE

Hereinafter, the present invention will be more specifically described with reference to Synthesis Examples, Comparative Synthesis Examples, Examples, and Comparative Examples. However, the present invention is not limited thereto.

### Synthesis of (A) Organic Polymer

Polymer compounds (A-1) to (A-15) of the organic polymer (A) and comparative polymer compounds (R-1) to (R-2) were synthesized. For preparing these polymer compounds, monomers (J1) to (J14) shown below were used.

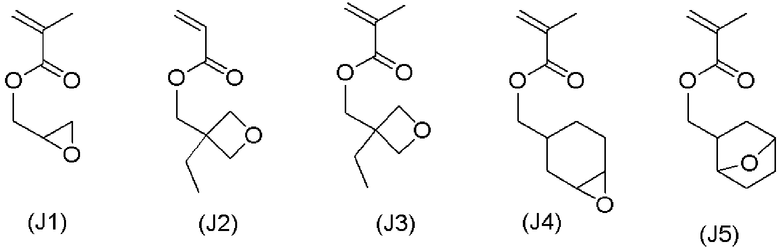

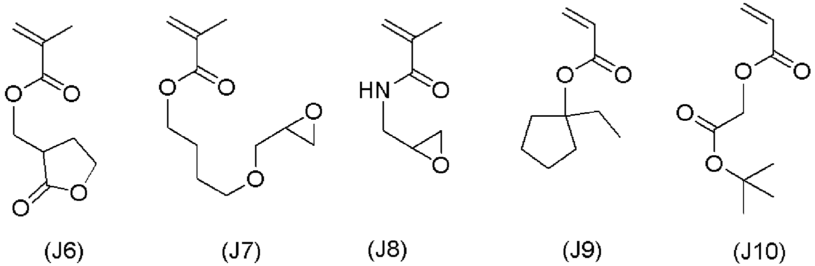

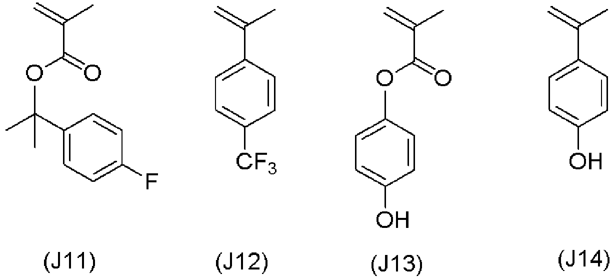

### Synthesis Example 1: Synthesis of Polymer Compound (A-1)

100 g of Monomer 1 (Raw Material J1) and 290.0 g of propylene glycol monomethyl ether acetate (hereinafter referred to as "PGMEA") were measured into a 500 ml flask, followed by degasification while stirring to prepare a monomer solution. Into another 500 ml flask, 2.9 g of dimethyl 2,2-azobis(2-methylpropionate) (V-601 produced by Wako Pure Chemical Corporation) and 50.0 g of PGMEA were measured, and degassed while being stirred to prepare an initiator solution. Furthermore, into a 1L flask under a nitrogen atmosphere, 60 g of PGMEA was measured, degassed while being stirred, and thereafter heated till the internal temperature reached 80°C. The monomer solution and the initiator solution were simultaneously and separately added over 4 hours. After their addition, the resultant was heated and stirred for 16 hours, and thereafter cooled to a room temperature. The resulting polymerization solution was added dropwise to 1,500 g of stirred hexane, and a precipitated polymer was separated by filtration. Further, the polymer thus obtained was washed twice with 600 g of hexane, and then dried under vacuum at 50°C for 20 hours to obtain a white powdered polymer (A-1). As a result of GPC analysis, the weight average molecular weight (Mw) and dispersity (Mw/Mn) of the polymer compound (A-1) were respectively 10,000 and 2.0.

### Synthesis of Compounds (A-2) to (A-15)

The compounds (A-2) to (A-15) and (R-1) to (R-2) shown in Table 1 were obtained under the same reaction conditions as in Synthesis Example 1 except that Monomer 1, Monomer 2, and Monomer 3 were used in the preparation amounts shown in Table 1.

**[Table 1]**

| Synthe sis Exampl e | Monomer 1 | | Monomer 2 | | Monomer 3 | | Polymeriza tion agent | Polym er compo und | Mw | Mw /Mn |
|---|---|---|---|---|---|---|---|---|---|---|
| | Raw mater ial | 9 | Raw mater ial | 9 | Raw mater ial | 9 | 9 | | | |
| 1 | J1 | 100 | - | - | - | - | 2 . 9 | A-1 | 10000 | 2.0 |
| 2 | J2 | 100 | - | - | - | - | 2 . 4 | A-2 | 13200 | 2.3 |
| 3 | J3 | 58 | J4 | 42 | - | - | 1.5 | A-3 | 20000 | 2 . 4 |
| 4 | J4 | 92 | J9 | 8 | - | - | 1.4 | A-4 | 21000 | 2 . 1 |
| 5 | J4 | 46 | J5 | 46 | J9 | 8 | 2 . 9 | A-5 | 8500 | 2 . 1 |
| 6 | J4 | 45 | J6 | 40 | J10 | 15 | 3.3 | A-6 | 6000 | 2.3 |
| 7 | J3 | 48 | J7 | 40 | J9 | 12 | 1.9 | A-7 | 16000 | 2.5 |
| 8 | J8 | 100 | - | - | - | - | 2 . 9 | A-8 | 12000 | 2 . 1 |
| 9 | J4 | 60 | J8 | 35 | J10 | 5 | 1.3 | A-9 | 22000 | 2.3 |
| 10 | J1 | 90 | J11 | 10 | - | - | 1.2 | A-10 | 25000 | 2.5 |
| 11 | J1 | 40 | J2 | 30 | J11 | 30 | 1.2 | A-11 | 25000 | 2 . 4 |
| 12 | J3 | 60 | J4 | 30 | J12 | 10 | 1.3 | A-12 | 27000 | 2.3 |
| 13 | J3 | 65 | J8 | 30 | J11 | 5 | 1.6 | A-13 | 23000 | 2.3 |
| 14 | J3 | 80 | J11 | 20 | - | - | 1 . 9 | A-14 | 17000 | 2 . 2 |
| 15 | J4 | 50 | J6 | 35 | J13 | 16 | 2.3 | A-15 | 13000 | 2.5 |
| 16 | J10 | 100 | - | - | - | - | 2.0 | R-1 | 12000 | 2.0 |
| 17 | J14 | 100 | - | - | - | - | 2.3 | R-2 | 11000 | 2.0 |

### (B) Metal Sources (M-1) to (M-17)

As the metal source (metal salt), the following metal compounds were used.
(M-1): titanium(IV) 2-ethylhexanoate
(M-2): tris(2,2,6,6-tetramethyl-3,5-heptanedionato)chromium(III)
(M-3): tris(2,2,6,6-tetramethyl-3,5-heptanedionato)manganese(III)
(M-4): tris(2,2,6,6-tetramethyl-3,5-heptanedionato)iron(III)
(M-5): cobalt(II) 2-ethylhexanoate
(M-6): nickel(II) bis(hexafluoroacetylacetonate)
(M-7): copper(I) 2-ethylhexanoate
(M-8): zinc(II) 4-vinyl benzoate
(M-9): tetra(2,2,6,6-tetramethyl-3,5-heptanedionato)zirconium(IV)
(M-10): molybdenum(IV) 2-ethylhexanoate
(M-11): indium(III) ethylbutyrate
(M-12): tin(II) acetate
(M-13): tin(II) 2-ethylhexanoate
(M-14): tin(II) acetylacetonate
(M-15): tin(II) 4-fluorobenzeneacetate
(M-16): hafnium(IV) carboxyethyl acrylate
(M-17): bismuth(III) 2-ethylhexanoate

### Preparation of Composition for Forming Adhesive Film (UDL-1 to 31, Comparative Example UDL-1 to 4)

For preparation of the composition for forming an adhesive film, the above polymer compounds (A-1) to (A-15) and (R-1) to (R-2), the metal sources (M-1) to (M-17), thermal acid generators (AG1) to (AG3), photoacid generators (AG4) to (AG5), crosslinking agents (XL1) to (XL2), and a high-boiling-point solvent (C1: ethylene glycol dibenzyl ether, boiling point of 364°C) were used. They were dissolved in an organic solvent containing 0.001% by mass of PF636 (produced by OMNOVA Solutions Inc.) in the proportions shown in Tables 2-1 to 2-2, and thereafter filtered through a 0.1 um filter made of a fluororesin, thereby respectively preparing the compositions for forming an adhesive film (UDL-1 to 31, Comparative Example UDL-1 to 4).

(CH₃CH₂)₃N⁺H C₄F₉SO₃⁻ (AG1)

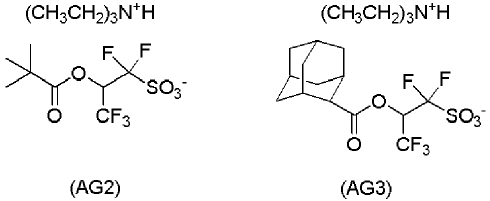

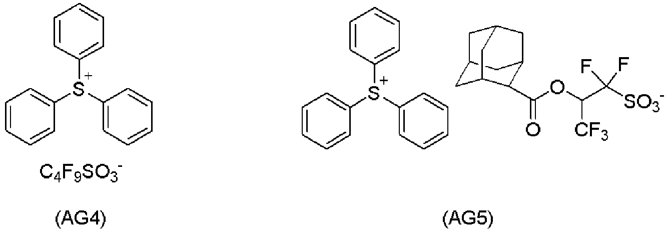

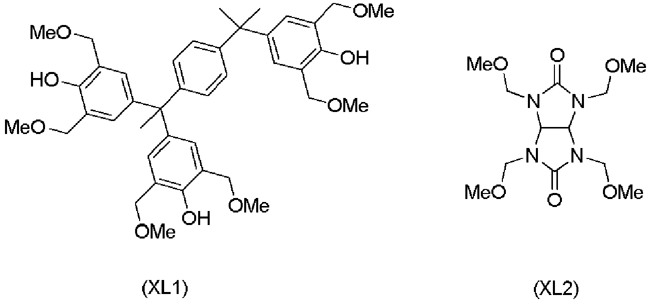

**[Table 2-1]**

| Composit ion for forming adhesive film | Organic polymer | Metal source | Thermal acid generat or | Photo acid gener ator | Crossl inking agent | High-boiling -point solvent | Solvent |
|---|---|---|---|---|---|---|---|
| | parts by mass | parts by mass | parts by mass | parts by mass | parts by mass | parts by mass | parts by mass |
| UDL-1 | (A-1) (1) | M-13 (0.2) | | - | - | - | PGMEA/PGEE (50/50) |
| UDL-2 | (A-2) (1) | M-13 (0.2) | AG1 (0.2) | - | - | - | PGMEA/PGEE (50/50) |
| UDL-3 | (A-3) (1) | M-13 (0.2) | AG1 (0.2) | - | - | - | PGMEA/PGEE (50/50) |
| UDL-4 | (A-4) (1) | M-13 (0.2) | AG1 (0.2) | - | - | - | PGMEA/PGEE (50/50) |
| UDL-5 | (A-5) (1) | M-13 (0.2) | AG1 (0.2) | - | - | - | PGMEA/PGEE (50/50) |
| UDL-6 | (A-6) (1) | M-13 (0.2) | AG1 (0.2) | - | - | - | PGMEA/PGEE (50/50) |
| UDL-7 | (A-7) (1) | M-13 (0.2) | AG1 (0.2) | - | - | - | PGMEA/PGEE (50/50) |
| UDL-8 | (A-8) (1) | M-13 (0.2) | AG2 (0.2) | - | - | - | PGMEA/PGEE (50/50) |
| UDL-9 | (A-9) (1) | M-13 (0.2) | AG3 (0.2) | - | - | - | PGMEA/PGEE (50/50) |
| UDL-10 | (A-10) (1) | M-13 (0.2) | AG1 (0.2) | AG4 (0.4) | - | - | PGMEA/PGEE (50/50) |
| UDL-11 | (A-11) (1) | M-13 (0.2) | AG2 (0.2) | AG5 (0.4) | - | - | PGMEA/PGEE (50/50) |
| UDL-12 | (A-12) (1) | M-13 (0.2) | AG1 (0.2) | - | XL1 (0.5) | - | PGMEA/PGEE (50/50) |
| UDL-13 | (A-13) (1) | M-13 (0.2) | AG1 (0.2) | - | XL2 (0.5) | - | PGMEA/PGEE (50/50) |
| UDL-14 | (A-14) (1) | M-13 (0.2) | AG1 (0.2) | - | - | C1 (5) | PGMEA/PGEE (50/50) |
| UDL-15 | (A-15) (1) | M-13 (0.2) | AG1 (0.2) | - | - | | PGMEA/PGEE (50/50) |
| UDL-16 | (A-3) (1) | M-1 (0.2) | AG1 (0.2) | | | | PGMEA/PGEE (50/50) |
| UDL-17 | (A-3) (1) | M-2 (0.2) | AG1 (0.2) | | | | PGMEA/PGEE (50/50) |
| UDL-18 | (A-3) (1) | M-3 (0.2) | AG1 (0.2) | | | | PGMEA/PGEE (50/50) |
| UDL-19 | (A-3) (1) | M-4 (0.2) | AG1 (0.2) | | | | PGMEA/PGEE (50/50) |
| UDL-20 | (A-3) (1) | M-5 (0.2) | AG1 (0.2) | | | | PGMEA/PGEE (50/50) |

**[Table 2-2]**

| Composit ion for forming adhesive film | Organic polymer | Metal source | Thermal acid generat or | Photo acid gener ator | Crossl inking agent | High-boiling -point solvent | Solvent |
|---|---|---|---|---|---|---|---|
| | parts by mass | parts by mass | parts by mass | parts by mass | parts by mass | parts by mass | parts by mass |
| UDL-21 | (A-3) (1) | M-6 (0.2) | AG1 (0.2) | | | | PGMEA/PGEE (50/50) |
| UDL-22 | (A-3) (1) | M-7 (0.2) | AG1 (0.2) | | | | PGMEA/PGEE (50/50) |
| UDL-23 | (A-3) (1) | M-8 (0.2) | AG1 (0.2) | | | | PGMEA/PGEE (50/50) |
| UDL-24 | (A-3) (1) | M-9 (0.2) | AG1 (0.2) | | | | PGMEA/PGEE (50/50) |
| UDL-25 | (A-3) (1) | M-10 (0.2) | AG1 (0.2) | | | | PGMEA/PGEE (50/50) |
| UDL-26 | (A-3) (1) | M-11 (0.2) | AG1 (0.2) | | | | PGMEA/PGEE (50/50) |
| UDL-27 | (A-3) (1) | M-12 (0.2) | AG1 (0.2) | | | | PGMEA/PGEE (50/50) |
| UDL-28 | (A-3) (1) | M-14 (0.2) | AG1 (0.2) | | | | PGMEA/PGEE (50/50) |
| UDL-29 | (A-3) (1) | M-15 (0.2) | AG1 (0.2) | | | | PGMEA/PGEE (50/50) |
| UDL-30 | (A-3) (1) | M-16 (0.2) | AG1 (0.2) | | | | PGMEA/PGEE (50/50) |
| UDL-31 | (A-3) (1) | M-17 (0.2) | AG1 (0.2) | | | | PGMEA/PGEE (50/50) |
| Comp.Ex. UDL-1 | (A-3) (1) | - | AG1 (0.2) | | | | PGMEA/PGEE (50/50) |
| Comp.Ex. UDL-2 | (R-1) (1) | M-13 (0.2) | AG1 (0.2) | | | | PGMEA/PGEE (50/50) |
| Comp.Ex. UDL-3 | (R-2) (1) | M-13 (0.2) | AG1 (0.2) | | | | PGMEA/PGEE (50/50) |
| Comp.Ex. UDL-4 | - | M-13 (0.2) | - | | | | PGEE (100) |

### Examples 1-1 to 1-31, Comparative Example 1-1 to 1-4: Solvent Resistance Evaluation

The composition for forming an adhesive film (UDL-1 to 31, Comparative Example UDL-1 to 4) as prepared above was applied on a silicon substrate and baked at 250°C for 60 seconds. Then, film thickness was measured from the center to the outer periphery of the substrate, and the average film thickness (a[nm]) was calculated. Next, a PGMEA solvent was dispensed thereon, left as it was for 30 seconds, spin-dried, and baked at 100°C for 60 seconds to evaporate the PGMEA. Then, the film thickness (b[nm]) was measured. The difference between the film thickness before and after the PGMEA treatment was determined (film remaining percentage: (b/a)×100).

**[Table 3]**

| Examples | Composition for forming adhesive film | Baking temperature | Film thickness after film formation:a | Film thickness after solvent treatment:b | b/a x100 |
|---|---|---|---|---|---|
| | | | Å | Å | % |
| Example 1-1 | UDL-1 | 250°C | 103.2 | 99.5 | 96% |
| Example 1-2 | UDL-2 | 250°C | 104.2 | 103.8 | 100% |
| Example 1-3 | UDL-3 | 250°C | 104.3 | 103.7 | 99% |
| Example 1-4 | UDL-4 | 250°C | 102.3 | 101.4 | 99% |
| Example 1-5 | UDL-5 | 250°C | 100.9 | 100.8 | 100% |
| Example 1-6 | UDL-6 | 250°C | 101.6 | 100.6 | 99% |
| Example 1-7 | UDL-7 | 250°C | 100.3 | 99.3 | 99% |
| Example 1-8 | UDL-8 | 250°C | 102.2 | 101.1 | 99% |
| Example 1-9 | UDL-9 | 250°C | 100.7 | 99.6 | 99% |
| Example 1-10 | UDL-10 | 250°C | 100.3 | 99.3 | 99% |
| Example 1-11 | UDL-11 | 250°C | 99.8 | 98 . 9 | 99% |
| Example 1-12 | UDL-12 | 250°C | 100.5 | 100.5 | 100% |
| Example 1-13 | UDL-13 | 250°C | 100.0 | 99.6 | 100% |
| Example 1-14 | UDL-14 | 250°C | 99.8 | 99.3 | 99% |
| Example 1-15 | UDL-15 | 250°C | 101.4 | 100.3 | 99% |
| Example 1-16 | UDL-16 | 250°C | 100.7 | 100.5 | 100% |
| Example 1-17 | UDL-17 | 250°C | 101.3 | 100.7 | 99% |
| Example 1-18 | UDL-18 | 250°C | 104.3 | 103.3 | 99% |
| Example 1-19 | UDL-19 | 250°C | 103.9 | 103.4 | 100% |
| Example 1-20 | UDL-20 | 250°C | 104.0 | 103.6 | 100% |
| Example 1-21 | UDL-21 | 250°C | 104.3 | 103.7 | 99% |
| Example 1-22 | UDL-22 | 250°C | 103.6 | 102.8 | 99% |
| Example 1-23 | UDL-23 | 250°C | 103.9 | 102.8 | 99% |
| Example 1-24 | UDL-24 | 250°C | 104.3 | 103.3 | 99% |
| Example 1-25 | UDL-25 | 250°C | 104.3 | 104.1 | 100% |
| Example 1-26 | UDL-26 | 250°C | 104.5 | 104.0 | 100% |
| Example 1-27 | UDL-27 | 250°C | 104.4 | 103.9 | 100% |
| Example 1-28 | UDL-28 | 250°C | 104.7 | 104.3 | 100% |
| Example 1-29 | UDL-29 | 250°C | 105.0 | 104.6 | 100% |
| Example 1-30 | UDL-30 | 250°C | 104.1 | 103.8 | 100% |
| Example 1-31 | UDL-31 | 250°C | 103.9 | 103.2 | 99% |
| Comparative Example 1-1 | Comparative Example UDL-1 | 250°C | 89.3 | 88.4 | 99% |
| Comparative Example 1-2 | Comparative Example UDL-2 | 250°C | 100.6 | 99.7 | 99% |
| Comparative Example 1-3 | Comparative Example UDL-3 | 250°C | 98.6 | 97.4 | 99% |
| Comparative Example 1-4 | Comparative Example UDL-4 | 250°C | 94.3 | 94.0 | 100% |

As shown in Table 3, it was found that all the compositions for forming an adhesive film of the present invention (UDL-1 to 31) had good film formability, hardly caused a decrease in the film thickness due to the solvent treatment, and yielded a film with good solvent resistance. Additionally, it was found that the use of the acid generator lead to better solvent resistance.

### Examples 2-1 to 2-31, Comparative Examples 2-1 to 2-4: Patterning Test (Sensitivity Evaluation)

On a silicon wafer with 100 nm of SiO₂ deposited thereon, a SOC film (ODL-306, carbon content: 61 atomic%) produced by Shin-Etsu Chemical Co., Ltd. was applied by spin coating and baked at 350°C for 60 seconds, thereby forming a carbon film having a film thickness of 40 nm as an organic underlayer film. Next, a SOG film (SHB-A940, Si content: 25 atomic%) produced by Shin-Etsu Chemical Co., Ltd. was applied on the organic resist underlayer film by spin coating and baked at 220°C for 60 seconds, thereby forming a carbon film having a film thickness of 20 nm. The above composition for forming an adhesive film (UDL-1 to 31 and Comparative Example UDL-1 to 4) was applied and heated at 220°C for 60 seconds using a hot plate, thereby forming an adhesive film having a film thickness of 10 nm.

Next, the resist material shown in Table 4 was spin-coated on the above adhesive film and pre-baked at 105°C for 60 seconds using a hot plate, thereby forming a resist film having a film thickness of 35 nm. This was exposed using an EUV scanner NXE3300 produced by ASML Holding N.V. (NA 0.33, σ 0.9/0.6, quadrupole illumination, L/S pattern at a pitch 44 nm on-wafer size), subjected to PEB on a hot plate at 100°C for 60 seconds, and developed in a 2.38% by mass of TMAH aqueous solution for 30 seconds, thereby obtaining a pattern having a line dimension of 22 nm.

The length of this line dimension was measured using a CD-SEM (CG5000) produced by Hitachi High-Tech Corporation, and pattern collapse was determined. It was evaluated as good when no pattern collapse was observed, and evaluated as poor when pattern collapse was observed. Additionally, the cross-sectional shape was observed using an electron microscope (S-4800) produced by Hitachi High-Tech Corporation, and evaluated as good when there was no footing profile and evaluated as poor when there was a footing profile.

Furthermore, the minimum dimension at which the line would be resolved without collapsing was determined by increasing the exposure dose and narrowing the line dimension, and reported as collapse limit (nm). The smaller value is preferable since it indicates higher collapse resistance.

Furthermore, the exposure dose at which the line dimension of 22 nm could be obtained was evaluated for the sensitivity. It was determined that the smaller the exposure dose, the better the contribution thereof to sensitivity enhancement of the resist upper layer film.

The results are shown in Table 5.

### Polymer :

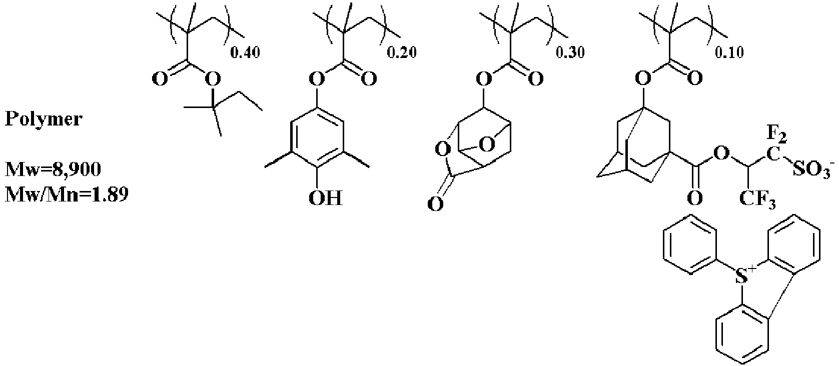

### Quencher:

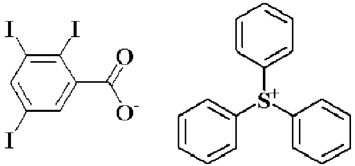

### Sensitizer:

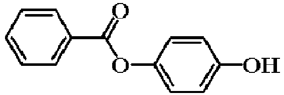

Surfactant: FC-4430 produced by 3M Company.

**[Table 4]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

- Organic solvent:

| | |
|---|---|
| PGMEA | (propylene glycol monomethyl ether acetate) |
| CyHO | (cyclohexanone) |
| PGME | (propylene glycol monomethyl ether) |

**[Table 5]**

| Examples | Composition for forming adhesive film | L/S patterning test | | |
|---|---|---|---|---|
| | | Sensitivity mJ/cm² | Cross section after development | Collapse limit (nm) |
| Example 2-1 | UDL-1 | 22.7 | Vertical profile | 14.8 |
| Example 2-2 | UDL-2 | 22.8 | Vertical profile | 14.6 |
| Example 2-3 | UDL-3 | 22.5 | Vertical profile | 13.9 |
| Example 2-4 | UDL-4 | 22.6 | Vertical profile | 14.2 |
| Example 2-5 | UDL-5 | 22.5 | Vertical profile | 14.3 |
| Example 2-6 | UDL-6 | 22.5 | Vertical profile | 14.2 |
| Example 2-7 | UDL-7 | 22.7 | Vertical profile | 14.1 |
| Example 2-8 | UDL-8 | 22.8 | Vertical profile | 14.8 |
| Example 2-9 | UDL-9 | 22.6 | Vertical profile | 14.5 |
| Example 2-10 | UDL-10 | 22.4 | Vertical profile | 13.7 |
| Example 2-11 | UDL-11 | 22.4 | Vertical profile | 13.6 |
| Example 2-12 | UDL-12 | 22.3 | Vertical profile | 13.5 |
| Example 2-13 | UDL-13 | 22.4 | Vertical profile | 13.6 |
| Example 2-14 | UDL-14 | 22.4 | Vertical profile | 13.6 |
| Example 2-15 | UDL-15 | 22.4 | Vertical profile | 13.5 |
| Example 2-16 | UDL-16 | 23.9 | Vertical profile | 13.8 |
| Example 2-17 | UDL-17 | 23.8 | Vertical profile | 13.9 |
| Example 2-18 | UDL-18 | 23.7 | Vertical profile | 14.0 |
| Example 2-19 | UDL-19 | 23.8 | Vertical profile | 14.1 |
| Example 2-20 | UDL-20 | 23.6 | Vertical profile | 14.0 |
| Example 2-21 | UDL-21 | 23.7 | Vertical profile | 14.1 |
| Example 2-22 | UDL-22 | 23.5 | Vertical profile | 14.2 |
| Example 2-23 | UDL-23 | 23.3 | Vertical profile | 14.0 |
| Example 2-24 | UDL-24 | 24.4 | Vertical profile | 13.9 |
| Example 2-25 | UDL-25 | 24.7 | Vertical profile | 14.2 |
| Example 2-26 | UDL-26 | 23.2 | Vertical profile | 14.2 |
| Example 2-27 | UDL-27 | 22,7 | Vertical profile | 14.0 |
| Example 2-28 | UDL-28 | 22.2 | Vertical profile | 13.9 |
| Example 2-29 | UDL-29 | 22.6 | Vertical profile | 13.9 |
| Example 2-30 | UDL-30 | 22.5 | Vertical profile | 14.0 |
| Example 2-31 | UDL-31 | 23.1 | Vertical profile | 14.2 |
| Comparative Example 2-1 | Comparative Example UDL-1 | 25.4 | Vertical profile | 13.7 |
| Comparative Example 2-2 | Comparative Example UDL-2 | 22.9 | Vertical profile | 20.5 |
| Comparative Example 2-3 | Comparative Example UDL-3 | 22.7 | Vertical profile | 19.7 |
| Comparative Example 2-4 | Comparative Example UDL-4 | Pattern collapse | Pattern collapse | Pattern collapse |

As shown in Table 5, in Examples 2-1 to 2-31 each using the composition for forming an adhesive film of the present invention, formation of a pattern having a line width of 22 nm using EUV exposure yielded a pattern cross section of a vertical profile, and no pattern collapse was recognized. On the other hand, in Comparative Example 2-4 using Comparative Example UDL-4 containing no organic polymer, collapse of the resist pattern was observed. Additionally, in Comparative Examples 2-2 and 2-3 respectively using Comparative Example UDL-2 and 3 where the organic polymer (A) contained the polymer compound containing none of the repeating units represented by the following formulae (1) and (2), it was found that prevention effect on collapse of a fine line pattern was smaller as compared with Examples 2-1 to 2-31.

Furthermore, it was found that when the composition for forming an adhesive film of the present invention was used for an adhesive film, the resist pattern could be formed with high sensitivity (Example UDL-1 to 31). In Examples 2-16 to 2-31, the compositions for forming an adhesive film UDL-16 to 31 were evaluated, where various metal sources (B) were added while the organic polymer of the compositions for forming an adhesive film was fixed to A3. In Examples 2-27 to 2-30 using the composition for forming an adhesive film containing Sn as the metal source (B), especially excellent sensitivity was exhibited. On the other hand, Comparative Example 2-1 with no metal source (B) added thereto resulted in poorer sensitivity.

As described above, the present invention is capable of forming an adhesive film that is excellent in adhesiveness to the upper layer resist, thus highly effective for controlling collapse of a fine line pattern, and also capable of contributing to sensitivity enhancement of the upper layer resist. Accordingly, the present invention is highly useful in the field of EUV lithography.

The present description encompasses the following inventions.
[1] A composition for forming an adhesive film that is formed between a silicon-containing middle layer film and a resist upper layer film, the composition comprising: (A) an organic polymer, (B) a metal source, and (C) an organic solvent, wherein the organic polymer (A) is a polymer compound containing one or both of repeating units represented by the following formulae (1) and (2), and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 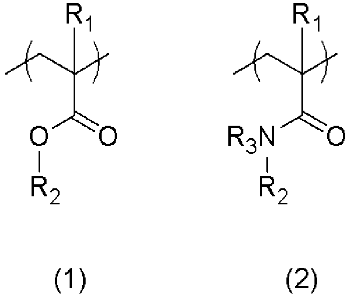 wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.
[2] The composition for forming an adhesive film according to [1], wherein the heterocyclic structure of R₂ in the formulae (1) and (2) contains an oxygen atom.
[3] The composition for forming an adhesive film according to [1] or [2], wherein R₂ in the formulae (1) and (2) represents a monovalent organic group containing a group selected from the following formulae (R₂-1) to (R₂-3), 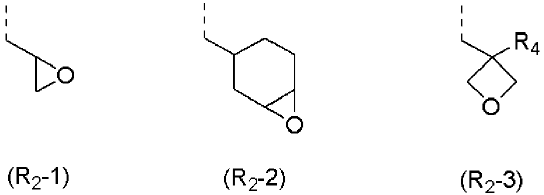 wherein R₄ represents a hydrogen atom or an alkyl group having 1 to 10 carbon atoms; and a broken line represents a bonding arm.
[4] The composition for forming an adhesive film according to any one of [1] to [3], wherein the organic polymer (A) is a polymer compound further containing any of repeating units represented by the following formula (3a) or (3b), 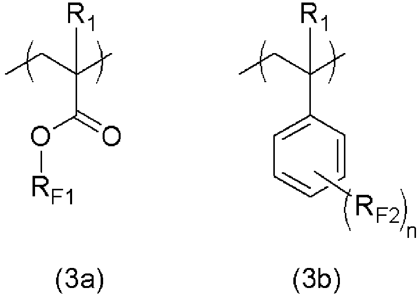 wherein R_{F1} represents a monovalent organic group having 1 to 20 carbon atoms and containing at least one F atom; R_{F2} represents a F atom or a monovalent organic group having 1 to 10 carbon atoms and containing one or more F atoms; R₁ is the same as defined in the above formula (1); and "n" represents 1 to 5.
[5] The composition for forming an adhesive film according to any one of [1] to [4], wherein the organic polymer (A) is a polymer compound having a weight average molecular weight of 6,000 to 50,000.
[6] The composition for forming an adhesive film according to any one of [1] to [5], wherein the organic polymer (A) is a polymer compound having a dispersity of 3.0 or less determined by weight average molecular weight/number average molecular weight.
[7] The composition for forming an adhesive film according to any one of [1] to [6], wherein the metal source (B) is a salt of the metal with a monovalent to tetravalent carboxylic acid having 1 to 30 carbon atoms.
[8] The composition for forming an adhesive film according to any one of [1] to [7], wherein the metal source (B) has a structure represented by the following formula (B-1), 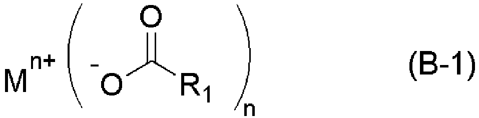 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.
[9] The composition for forming an adhesive film according to [8], wherein R₁ in the formula (B-1) represents a saturated or unsaturated hydrocarbon group having 1 to 10 carbon atoms.
[10] The composition for forming an adhesive film according to [8] or [9], wherein R₁ in the formula (B-1) represents a branched alkyl group having 3 to 10 carbon atoms.
[11] The composition for forming an adhesive film according to any one of [1] to [10], wherein the metal of the metal source (B) is Sn.
[12] The composition for forming an adhesive film according to any one of [1] to [11], further comprising at least one or more of (D) a thermal acid generator, (E) a photoacid generator, (F) a crosslinking agent, and (G) a surfactant.
[13] The composition for forming an adhesive film according to any one of [1] to [12], wherein the organic solvent (C) is a mixture of one or more kinds of organic solvents having a boiling point of less than 180°C and one or more kinds of organic solvents having a boiling point of 180°C or higher ((C-1) a high-boiling-point solvent).
[14] A patterning process for forming a pattern in a substrate to be processed, comprising steps of: (I-1) forming a resist underlayer film on the substrate to be processed; (I-2) forming a silicon-containing resist middle layer film on the resist underlayer film; (I-3) applying the composition for forming an adhesive film according to any one of [1] to [13] on the silicon-containing resist middle layer film and thereafter performing heat treatment to form an adhesive film; (I-4) forming a resist upper layer film on the adhesive film using a photoresist material; (I-5) forming a pattern in the resist upper layer film by developing the resist upper layer film using a developer after pattern exposure; (I-6) transferring the pattern to the adhesive film by dry etching while using the resist upper layer film having the formed pattern as a mask; (I-7) transferring the pattern to the silicon-containing resist middle layer film by dry etching while using the adhesive film having the formed pattern as a mask; (I-8) transferring the pattern to the resist underlayer film by dry etching while using the silicon-containing resist middle layer film having the transferred pattern as a mask; and (I-9) transferring the pattern to the substrate to be processed by dry etching while using the resist underlayer film having the transferred pattern as a mask.
[15] A patterning process for forming a pattern in a substrate to be processed, comprising steps of: (II-1) forming a resist underlayer film on the substrate to be processed; (II-2) forming an inorganic hard mask middle layer film selected from a silicon oxide film, a silicon nitride film, and a silicon oxynitride film on the resist underlayer film; (II-3) applying the composition for forming an adhesive film according to any one of [1] to [13] on the inorganic hard mask middle layer film and thereafter performing heat treatment to form an adhesive film; (II-4) forming a resist upper layer film on the adhesive film using a photoresist material; (II-5) forming a pattern in the resist upper layer film by developing the resist upper layer film using a developer after pattern exposure; (II-6) transferring the pattern to the adhesive film by dry etching while using the resist upper layer film having the formed pattern as a mask; (II-7) transferring the pattern to the inorganic hard mask middle layer film by dry etching while using the adhesive film having the formed pattern as a mask; (II-8) transferring the pattern to the resist underlayer film by dry etching while using the inorganic hard mask middle layer film having the transferred pattern as a mask; and (II-9) transferring the pattern to the substrate to be processed by dry etching while using the resist underlayer film having the transferred pattern as a mask.
[16] The patterning process according to [14], wherein the pattern exposure is performed using EUV light in the step (I-5) .
[17] The patterning process according to [15], wherein the pattern exposure is performed using EUV light in the step (II-5).

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming an adhesive film that is formed between a silicon-containing middle layer film and a resist upper layer film, the composition comprising:
(A) an organic polymer, (B) a metal source, and (C) an organic solvent,
wherein the organic polymer (A) is a polymer compound containing one or both of repeating units represented by the following formulae (1) and (2), and
the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone, 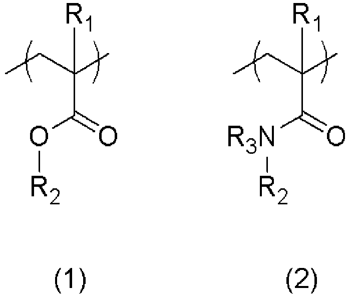
wherein R₁ represents a hydrogen atom or a methyl group; R₂ represents a monovalent organic group having 2 to 20 carbon atoms and containing a heterocyclic structure; and R₃ represents a hydrogen atom or a linear or branched alkyl group having 1 to 3 carbon atoms.

2. The composition for forming an adhesive film according to claim 1, wherein the heterocyclic structure of R₂ in the formulae (1) and (2) contains an oxygen atom.

3. The composition for forming an adhesive film according to claim 1, wherein R₂ in the formulae (1) and (2) represents a monovalent organic group containing a group selected from the following formulae (R₂-1) to (R₂-3), 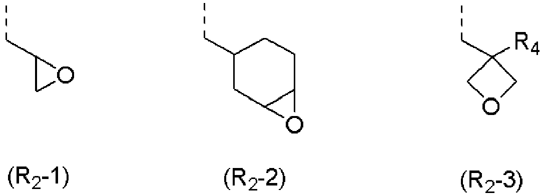 wherein R₄ represents a hydrogen atom or an alkyl group having 1 to 10 carbon atoms; and a broken line represents a bonding arm.

4. The composition for forming an adhesive film according to claim 1, wherein the organic polymer (A) is a polymer compound further containing any of repeating units represented by the following formula (3a) or (3b), 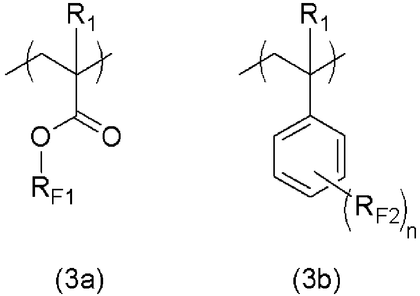 wherein R_{F1} represents a monovalent organic group having 1 to 20 carbon atoms and containing at least one F atom; R_{F2} represents a F atom or a monovalent organic group having 1 to 10 carbon atoms and containing one or more F atoms; R₁ is the same as defined in the above formula (1); and "n" represents 1 to 5.

5. The composition for forming an adhesive film according to claim 1, wherein the organic polymer (A) is a polymer compound having a weight average molecular weight of 6,000 to 50,000.

6. The composition for forming an adhesive film according to claim 1, wherein the organic polymer (A) is a polymer compound having a dispersity of 3.0 or less determined by weight average molecular weight/number average molecular weight.

7. The composition for forming an adhesive film according to claim 1, wherein the metal source (B) is a salt of the metal with a monovalent to tetravalent carboxylic acid having 1 to 30 carbon atoms.

8. The composition for forming an adhesive film according to claim 1, wherein the metal source (B) has a structure represented by the following formula (B-1), 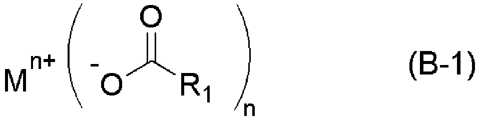 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.

9. The composition for forming an adhesive film according to claim 8, wherein R₁ in the formula (B-1) represents a saturated or unsaturated hydrocarbon group having 1 to 10 carbon atoms.

10. The composition for forming an adhesive film according to claim 8, wherein R₁ in the formula (B-1) represents a branched alkyl group having 3 to 10 carbon atoms.

11. The composition for forming an adhesive film according to claim 1, wherein the metal of the metal source (B) is Sn.

12. The composition for forming an adhesive film according to claim 1, further comprising at least one or more of (D) a thermal acid generator, (E) a photoacid generator, (F) a crosslinking agent, and (G) a surfactant.

13. The composition for forming an adhesive film according to claim 1, wherein the organic solvent (C) is a mixture of one or more kinds of organic solvents having a boiling point of less than 180°C and one or more kinds of organic solvents having a boiling point of 180°C or higher ((C-1) a high-boiling-point solvent).

14. A patterning process for forming a pattern in a substrate to be processed, comprising steps of:
(I-1) forming a resist underlayer film on the substrate to be processed;
(I-2) forming a silicon-containing resist middle layer film on the resist underlayer film;
(I-3) applying the composition for forming an adhesive film according to any one of claims 1 to 13 on the silicon-containing resist middle layer film and thereafter performing heat treatment to form an adhesive film;
(I-4) forming a resist upper layer film on the adhesive film using a photoresist material;
(I-5) forming a pattern in the resist upper layer film by developing the resist upper layer film using a developer after pattern exposure;
(I-6) transferring the pattern to the adhesive film by dry etching while using the resist upper layer film having the formed pattern as a mask;
(I-7) transferring the pattern to the silicon-containing resist middle layer film by dry etching while using the adhesive film having the formed pattern as a mask;
(I-8) transferring the pattern to the resist underlayer film by dry etching while using the silicon-containing resist middle layer film having the transferred pattern as a mask; and
(I-9) transferring the pattern to the substrate to be processed by dry etching while using the resist underlayer film having the transferred pattern as a mask, preferably,
wherein the pattern exposure is performed using EUV light in the step (I-5).

15. A patterning process for forming a pattern in a substrate to be processed, comprising steps of:
(II-1) forming a resist underlayer film on the substrate to be processed;
(II-2) forming an inorganic hard mask middle layer film selected from a silicon oxide film, a silicon nitride film, and a silicon oxynitride film on the resist underlayer film;
(II-3) applying the composition for forming an adhesive film according to any one of claims 1 to 13 on the inorganic hard mask middle layer film and thereafter performing heat treatment to form an adhesive film;
(II-4) forming a resist upper layer film on the adhesive film using a photoresist material;
(II-5) forming a pattern in the resist upper layer film by developing the resist upper layer film using a developer after pattern exposure;
(II-6) transferring the pattern to the adhesive film by dry etching while using the resist upper layer film having the formed pattern as a mask;
(II-7) transferring the pattern to the inorganic hard mask middle layer film by dry etching while using the adhesive film having the formed pattern as a mask;
(II-8) transferring the pattern to the resist underlayer film by dry etching while using the inorganic hard mask middle layer film having the transferred pattern as a mask; and
(II-9) transferring the pattern to the substrate to be processed by dry etching while using the resist underlayer film having the transferred pattern as a mask, preferably,
wherein the pattern exposure is performed using EUV light in the step (II-5).
